(19) Europäisches Patentamt

European Patent Office

Office européen des brevets

(11) **EP 1 101 283 B1**

(12) **FASCICULE DE BREVET EUROPEEN**

(45) Date de publication et mention
de la délivrance du brevet:
**03.07.2002 Bulletin 2002/27**

(21) Numéro de dépôt: **99936660.2**

(22) Date de dépôt: **30.07.1999**

(51) Int Cl.[7]: **H03H 17/02**

(86) Numéro de dépôt international:
**PCT/FR99/01902**

(87) Numéro de publication internationale:
**WO 00/07298 (10.02.2000 Gazette 2000/06)**

(54) **PROCEDE DE REALISATION DE FILTRES NUMERIQUES DE NYQUIST A INTERFERENCES NULLES ENTRE SYMBOLES, ET DISPOSITIF DE FILTRAGE CORRESPONDANT**

VERFAHREN ZUR HERSTELLUNG VON DIGITALEN NYQUIST FILTERN OHNE STÖRUNGEN ZWISCHEN SYMBOLEN UND ENTSPRECHENDE FILTERANORDNUNG

METHOD FOR PRODUCING DIGITAL NYQUIST FILTERS WITH NULL INTERFERENCE BETWEEN SYMBOLS AND CORRESPONDING FILTERING DEVICE

(84) Etats contractants désignés:
**DE GB**

(30) Priorité: **30.07.1998 FR 9809958**

(43) Date de publication de la demande:
**23.05.2001 Bulletin 2001/21**

(73) Titulaires:
• **FRANCE TELECOM**
**75015 Paris (FR)**
• **TELEDIFFUSION DE FRANCE**
**75732 Paris Cédex 15 (FR)**

(72) Inventeurs:
• **SIOHAN, Pierre**
**F-35200 Rennes (FR)**

• **PINCHON, Didier**
**F-31290 Vieillevigne (FR)**

(74) Mandataire: **Vidon, Patrice**
**Cabinet Patrice Vidon**
**Le Nobel (Bât. A)**
**Technopôle Atalante**
**2, allée Antoine Becquerel**
**BP 90333**
**35703 Rennes Cedex 7 (FR)**

(56) Documents cités:
• **56 - 93: "MULTIRATE DIGITAL FILTERS, FILTER BANKS, POLYPHASE NETWORKS, AND APPLICATIONS: A TUTORIAL" PROCEEDINGS OF THE IEEE, vol. 78, no. 1, 1 janvier 1990 (1990-01-01), pages 56-93, XP000125845**

## Description

Le domaine de l'invention est celui du filtrage de signaux numériques, plus précisément l'invention concerne la réalisation de filtres de Nyquist, tels que ceux utilisés par exemple dans les systèmes de transmission en bande de base et en monoporteuse.

Les filtres de Nyquist jouent un rôle essentiel dans les systèmes de transmission. Dans la plupart des cas, ce filtrage est réparti entre l'émission et la réception sous la forme de deux filtres dits en racine de Nyquist. A l'émission, le but est notamment de limiter la bande du signal émis. A la réception, le filtre doit éliminer les différents bruits pouvant altérer le signal utile, en particulier le bruit d'interférences dues à des canaux adjacents. Dans les systèmes modernes, ces filtres sont réalisés sous forme numérique. Il existe de nombreuses méthodes pour leur synthèse. Un élément clé de cette synthèse, outre bien sûr le respect des spécifications fréquentielles, est l'obtention d'une interférence entre symboles (IES) aussi réduite que possible.

Pour assurer les meilleures conditions possibles de transmission, on recherche, en général, des filtres à coefficients réels qui, idéalement, satisfont les critères suivants :

- interférence nulle entre symboles ;
- sélectivité fréquentielle ;
- filtres d'émisssion et de réception formant une paire adaptée ;
- linéarité de phase.

L'annexe 1 détaille ces différents aspects, et les contraintes correspondantes. Cette annexe, de même que les suivantes, fait bien sûr partie de la présente description à part entière.

Un système complet de transmission doit réaliser généralement également d'autres fonctions indispensables telles que :

- le filtrage analogique d'émission, qui a pour but de rejeter les harmoniques en sortie du filtre numérique, ainsi que le filtrage analogique de réception, qui a pour fonction de limiter à la seule bande utile le spectre du signal à échantillonner ;
- les conversions numérique - analogique (CNA), à l'émission, et analogique - numérique (CAN) à la réception.

L'invention concerne essentiellement l'obtention de filtres numériques, et on ne détaille donc pas les fonctions concernant la partie analogique. Il convient cependant de noter que, en pratique, le filtrage analogique à mettre en oeuvre est nettement moins contraignant au sens de la raideur des filtres, que celui du numérique. Plus précisément, la complexité de réalisation du filtre de réjection d'émision est en relation directe avec la valeur du facteur de suréchantillonnage retenu.

Quant aux convertisseurs, le fait le plus notable du point de vue du filtrage, est celui de la conversion numérique - analogique qui introduit un filtrage en sin(x)/x, qui peut être compensé classiquement par le filtrage analogique. Ce traitement peut également être réalisé en numérique.

Par ailleurs, pour des raisons de mise en oeuvre, les filtres sont généralement échantillonnés à fréquence double ou quadruple.

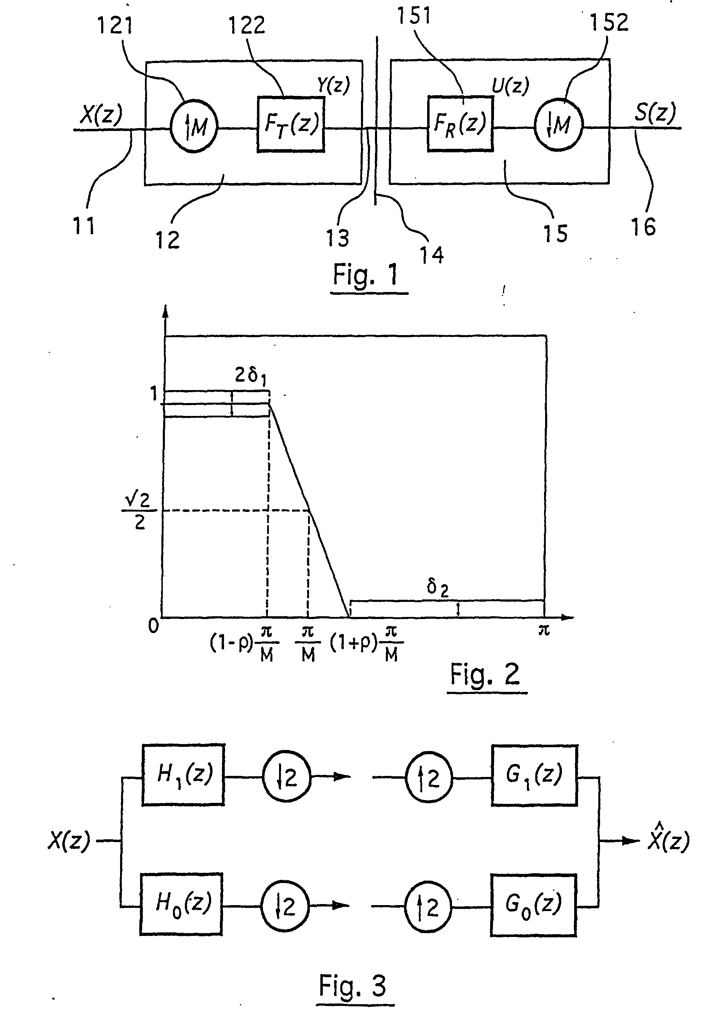

La figure 1 illustre la partie numérique d'un tel système de communication. Le signal à transmettre X(z) 11 alimente l'émetteur 12, qui délivre un signal filtré Y(z) 13 transmis via un canal de transmission 14 vers un récepteur 15 qui délivre le signal de sortie S(z) 16. Le signal X(z)11 est tout d'abord soumis à un suréchantillonnage 121 puis à un filtrage 122 $F_t(z)$. Dans le récepteur, le signal subit un filtrage de réception $F_r(z)$ 151, puis une décimation 152. Avec T le retard élémentaire lié au filtres numériques d'émission et de réception, on a $T_s = MT$, où $T_s$ est la durée symbole et M le facteur de sur-échantillonnage.

L'intérêt d'avoir un facteur de sur-échantillonnage élevé est notamment de faciliter la réalisation du filtre analogique qui va suivre. Un inconvénient est que cela augmente d'autant la vitesse du convertisseur (CNA). En pratique, le compromis le plus raisonnable correspond à une valeur de M = 2 ou 4. L'invention concerne spécifiquement le cas ou le facteur de sur-échantillonnage est M=4.

Des techniques de construction de filtres de Nyquist sont déjà connues. Toutefois, les différentes familles de filtres connues supposent toujours le relâchement d'une des propriétés souhaitées parmi l'interférence nulle entre symboles, la linéarité de phase (au moins à l'émission) et la paire de filtres adaptés.

Souvent, dans les systèmes de communication, on est conduit à accepter que le filtrage introduise une IES non nulle. Cela pose cependant parfois des problèmes, par exemple dans le cas de modulations à très grand nombre d'états (64, 256,...)

L'invention a notamment pour objectif de pallier ces inconvénients de l'état de l'art.

Plus précisément, un objectif de l'invention est de fournir un procédé de réalisation de filtres de Nyquist à interférences nulles entre symboles, et qui respecte également les conditions voulues de sélectivité fréquentielle et de linéarité de phase, dans une configuration en paire adaptée.

Un autre objectif de l'invention est de fournir un tel procédé qui permette une mise en oeuvre pratique aisée, des filtres obtenus, et qui prenne en compte certaines contraintes pratiques, telles que les effets de la quantification des coefficients. Plus précisément, l'invention a pour objectif de fournir un procédé garantissant le maintien de la propriété d'annulation de l'interférence entre symboles après cette quantification.

Un autre objectif est de fournir un tel procédé qui puisse être mis en oeuvre à l'aide d'une structure cascade, notamment sous la forme de treillis.

Ces objectifs, ainsi que d'autres qui apparaîtront par la suite, sont atteints selon l'invention à l'aide d'un procédé de réalisation d'un filtre numérique de Nyquist à interférences nulles entre symboles, destiné à traiter un signal physique transmis entre un émetteur et un récepteur via un canal de transmission. Ce filtre est un filtre symétrique $P(z) = F^2(z)$ d'ordre N mettant en oeuvre un facteur de suréchantillonnage M=4, et formant une paire adaptée comprenant un filtre d'émission et un filtre de réception, dont la décomposition polyphase de $F(z)$ peut s'écrire :

$$F(z) = F_0(z^4) + z^{-1}F_1(z^4) + z^{-2}F_2(z^4) + z^{-3}F_3(z^4).$$

Selon l'invention, N est choisi différent de 4n, n entier, et les coefficients de la décomposition polyphasé de $F(z)$ sont tels que :

.   Si N=4n+1,       $F_1(z)\hat{F}_1(z) + z^{-1}F_2(z)\hat{F}_2(z) = \gamma z^{-n}$

.   Si N=4n+2,       $2F_0(z)\hat{F}_0(z) + F_1^2(z) + z^{-1}F_3^2(z) = \gamma z^{-n}$

.   Si N=4n+3,       $F_0(z)\hat{F}_0(z) + F_1(z)\hat{F}_1(z) = \gamma z^{-n}$

$\hat{F}$ étant la symétrie miroir de F et $\gamma$ étant une constante non nulle.

Ainsi, le procédé de l'invention garantit, par construction, que l'IES est parfaitement nulle.

De façon préférentielle, N vaut 4n+3 ou 4n+1 et :

    ledit filtre d'émission effectue une interpolation par un facteur M=4 et présente une implantation correspondant à une décomposition polyphase dite de type II, telle que :

$$F(z) = \begin{bmatrix} z^{-3} & z^{-2} & z^{-1} & 1 \end{bmatrix} \begin{bmatrix} \hat{F}_0(z^4) \\ \hat{F}_1(z^4) \\ F_1(z^4) \\ F_0(z^4) \end{bmatrix}$$

-   et ledit filtre de réception effectue une décimation par un facteur M=4 et présente une implantation correspondant à une décomposition polyphase dite de type I, telle que :

$$F(z) = \begin{bmatrix} F_0(z^4) & F_1(z^4) & \hat{F}_1(z^4) & \hat{F}_0(z^4) \end{bmatrix} \begin{bmatrix} 1 \\ z^{-1} \\ z^{-2} \\ z^{-3} \end{bmatrix}$$

Les filtres ainsi obtenus sont simples à réaliser et à mettre en oeuvre.

Avantageusement, dans ledit filtre d'émission, on effectue une étape de filtrage suivie d'une étape d'interpolation par un facteur M=4. De même, dans ledit filtre de réception, on effectue avantageusement une étape de décimation par un facteur M=4 suivie d'une étape de filtrage.

Cette construction (structure permutée), permet de réduire d'un facteur 4 la cadence des opérations.

Selon un mode de réalisation préférentiel de l'invention, ledit filtre d'émission et/ou ledit filtre de réception présente une structure de réalisation sous forme d'au moins un treillis.

En effet, sous cette forme d'implantation, la contrainte de reconstruction parfaite est intégrée structurellement

De façon avantageuse, ledit filtre d'émission et ledit filtre de réception sont constitués chacun d'une paire de composantes polyphases donnée respectivement par les équations suivantes :

$$\begin{bmatrix} F_0 \\ F_1 \end{bmatrix} = g A(\alpha_n) \Lambda(z) A(\alpha_{n-1}) ... \Lambda(z) A(\alpha_0) \begin{bmatrix} 1 \\ 0 \end{bmatrix}$$

$$\begin{bmatrix} -\hat{F}_1 \\ \hat{F}_0 \end{bmatrix} = g A(\alpha_n) \Lambda(z) A(\alpha_{n-1}) ... \Lambda(z) A(\alpha_0) \begin{bmatrix} 0 \\ 1 \end{bmatrix}$$

avec:

$$A(\alpha) = \begin{bmatrix} 1 & \alpha \\ -\alpha & 1 \end{bmatrix} \qquad et \qquad \Lambda(z) = \begin{bmatrix} 1 & 0 \\ 0 & z^{-1} \end{bmatrix}$$

où g est une constante non nulle de normalisation et $\alpha_i$ des coefficients réels.

Selon un mode de réalisation particulier de l'invention, le procédé met en oeuvre une structure à deux treillis. Selon une autre approche, il peut mettre en oeuvre une structure à treillis unique, fonctionnant à une fréquence double.

L'invention concerne également, bien sûr, les dispositifs de filtrage obtenus à l'aide du procédé décrit ci-dessus. Il s'agit donc de dispositifs de filtrage d'un signal numérique de Nyquist à interférences nulles entre symboles, destiné à traiter un signal physique transmis entre un émetteur et un récepteur via un canal de transmission, basé sur un filtre symétrique $P(z) = F^2(z)$ d'ordre N mettant en oeuvre un facteur de suréchantillonnage M=4, et formant une paire adaptée comprenant un filtre d'émission et un filtre de réception, et dont la décomposition polyphase de F(z) s'écrit :

$$F(z) = F_0(z^4) + z^{-1} F_1(z^4) + z^{-2} F_2(z^4) + z^{-3} F_3(z^4).$$

Selon l'invention, N est différent de 4n, n entier, et :

.  Si N=4n+1,     $F_1(z)\hat{F}_1(z) + z^{-1} F_2(z)\hat{F}_2(z) = \gamma z^{-n}$
.  Si N=4n+2,     $2 F_0(z) F_0(z) + F_1^2(z) + z^{-1} F_3^2(z) = \gamma z^{-n}$
.  Si N=4n+3,     $F_0(z) F_0(z) + F_1(z) F_1(z) = \gamma z^{-n}$  F étant la symétrie miroir de F et $\gamma$ étant une constante non nulle.

D'autres caractéristiques et avantages de l'invention apparaîtront plus clairement à la lecture de la description suivant un mode de réalisation préférentiel donné à titre de simple exemple illustratif et non limitatif, et des dessins annexés parmi lesquels :

-  la figure 1, déjà commentée en préambule, illustre de façon schématique la partie numérique d'un système de communication ;
-  la figure 2, commentée dans l'annexe 1, représente une spécification fréquentielle typique d'un filtre de transmission ;
-  la figure 3, commentée en annexe 2, représente de façon générale un banc de filtres à 2 sous-bandes ;
-  la figure 4 illustre un mode de réalisation de la partie d'analyse d'un banc de filtres para-unitaires à 2 sous-bandes de la figure 3, sous forme de treillis ;
-  la figure 5 rappelle la structure d'un système de filtrage émission-réception, dans le cas linéaire et para-unitaire, commentée par la suite ;

- les figures 6a et 6b représentent, pour un filtre d'ordre 4n + 3, deux formes d'implantation du filtre d'émission de la figure 5, utilisant une décomposition polyphase respectivement en structure directe et en structure permutée ;
- les figures 7a et 7b illustrent, dans le cas de l'ordre 4n + 3, le filtre de réception de la figure 5, également dans le cadre de la décomposition polyphase, respectivement selon une structure directe et une structure permutée ;
- les figures 8a et 8b présentent le bloc treillis des filtres émission-réception des figures 6a, 6b, 7a et 7b, sous la forme respectivement d'un treillis direct et d'un treillis à sorties inversées ;
- la figure 9 illustre de façon détaillée un filtre racine de Nyquist d'émission d'ordre 4n + 3 à deux treillis, mettant en oeuvre les treillis inverses de la figure 8b ;
- la figure 10 présente un filtre de Nyquist de réception d'ordre 4n + 3, mettant en oeuvre quatre treillis ;
- la figure 10bis présente un filtre de réception mettant en oeuvre un treillis direct selon la figure 8a (voir annexe 4) ;

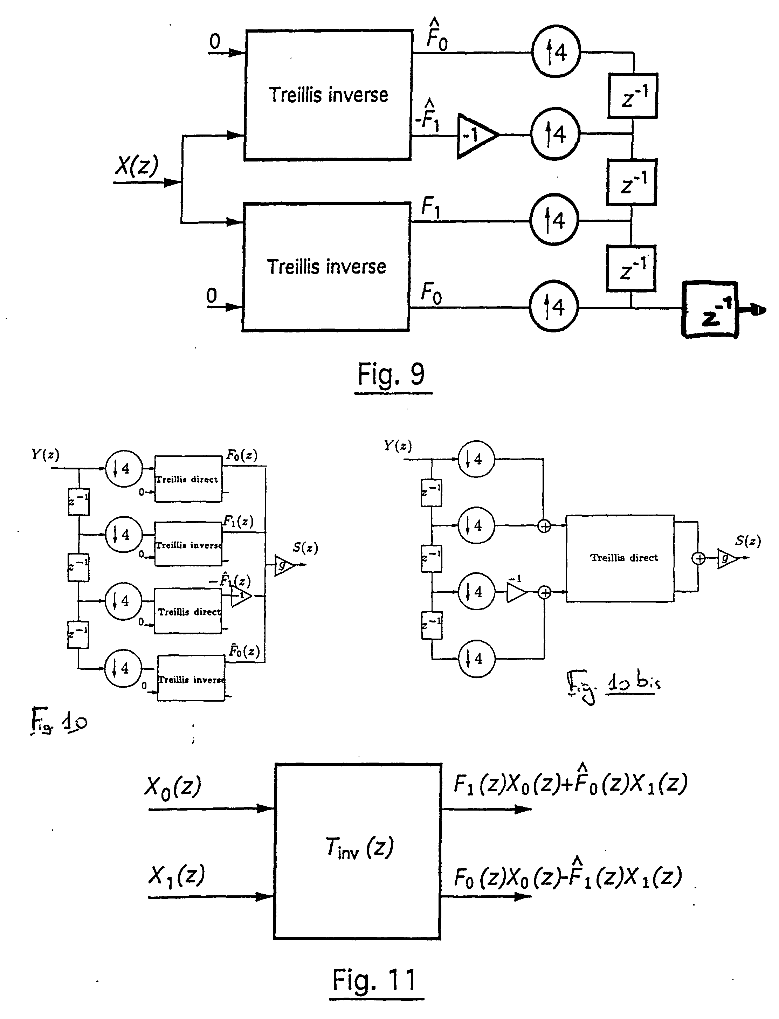

- la figure 11 rappelle les équations utilisées dans le cas du treillis inversé de la figure 9 ;

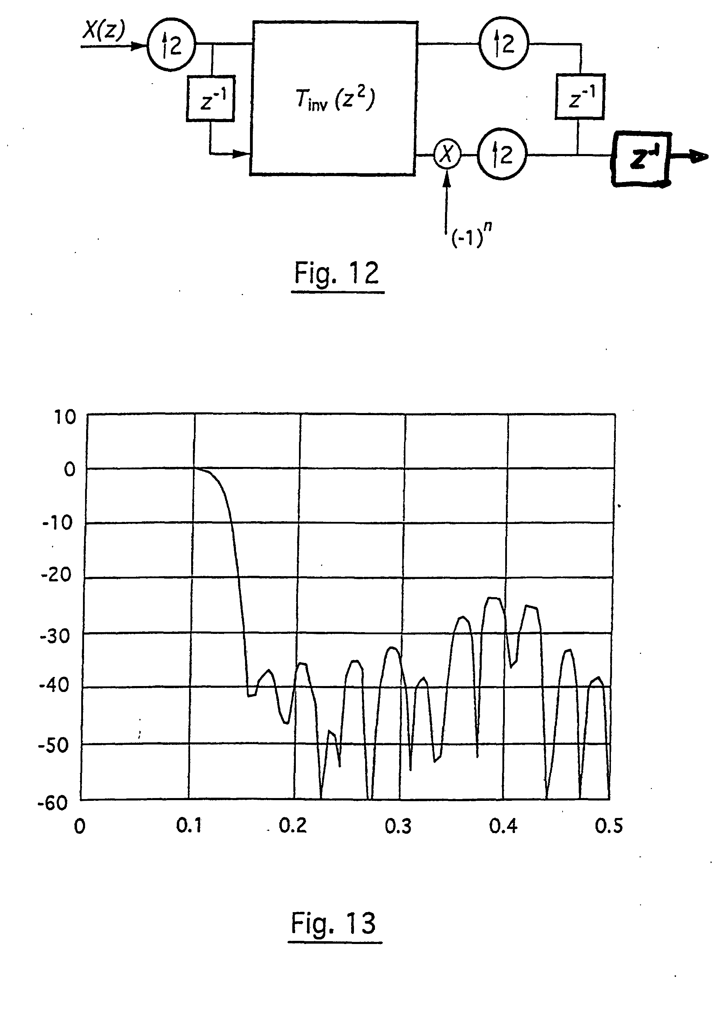

- la figure 12 présente un autre mode de réalisation du filtre d'émission, mettant en oeuvre un treillis unique et fonctionnant en cadence double ;
- la figure 13 présente un exemple de réponse en fréquences optimisées d'un filtre racine de Nyquist d'ordre 43, selon l'invention ;

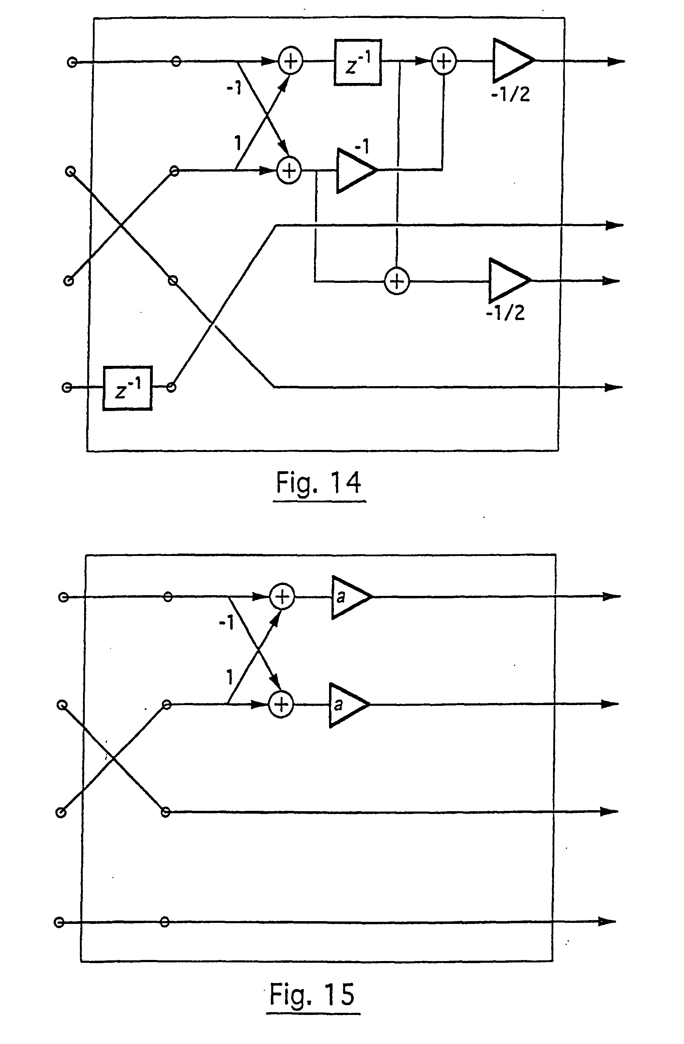

- la figure 14 illustre la réalisation d'un bloc Z, dans le cas d'un filtre d'ordre 4n + 2, tel que discuté en annexe 3 ;
- la figure 15 présente le bloc d'implantation de la matrice $P^T$, également dans le cadre du mode de réalisation de l'annexe 3 ;

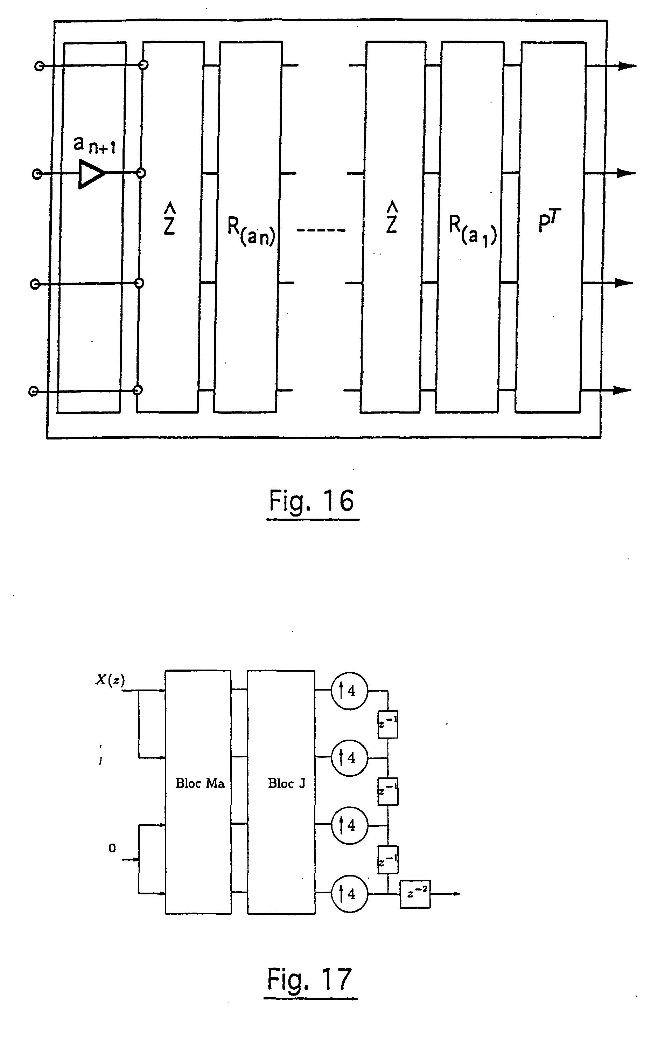

- la figure 16 présente le schéma complet d'implantation d'un bloc à 4 entrées et 4 sorties pour l'ordre 4n + 2, noté Ma, et discuté en annexe 3 ;
- la figure 17 présente un mode de réalisation d'un filtre demi Nyquist d'émission pour l'ordre 4n + 2 ;

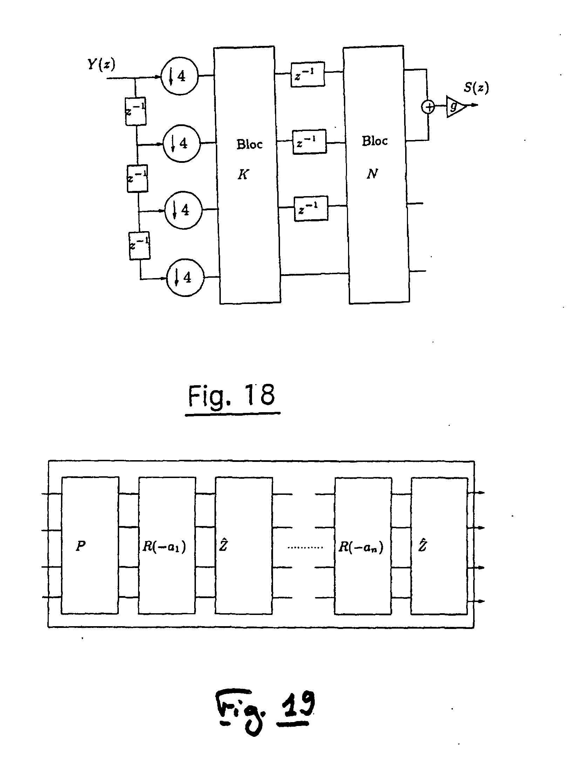

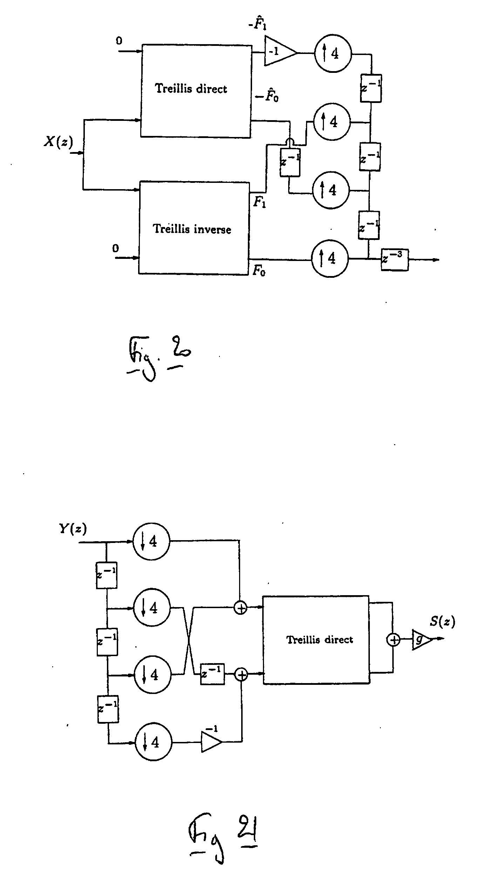

- les figures 18 et 19 (bloc N de la figure 18) illustrent un mode de réalisation demi-Nyquist de réception pour l'ordre 4n + 2, discuté en annexe 3 ;

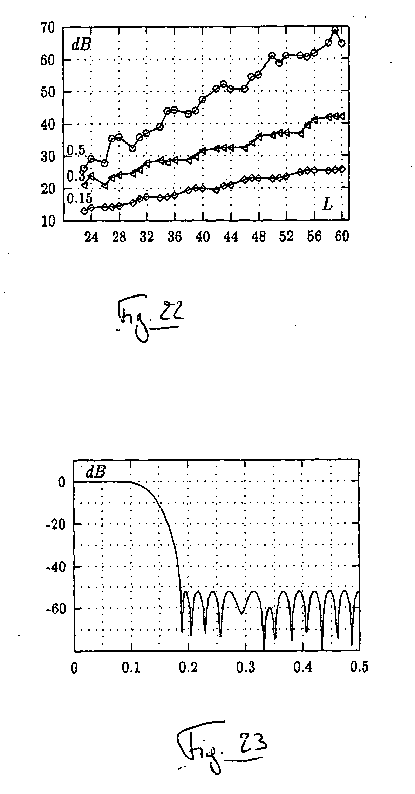

- les figures 20 et 21 présentent respectivement les filtres racine de Nyquist d'émission et de réception pour l'ordre 4n+1 (ou 4n+5), tels que discutés en annexe 5 ;
- les figures 22 et 23 illustrent les résultats obtenus à l'aide de la méthode de synthèse générique commentée en annexe 6.

Comme déjà mentionné, le procédé de l'invention permet la réalisation de filtres avec M = 4 vérifiant l'ensemble des critères suivants :

- IES nulle par construction ;
- filtres à phase linéaire ;
- filtres émission et réception formant une paire adaptée.

L'annexe 2 montre, après avoir développé l'analogie entre une paire de Nyquist avec M = 4 et un banc de filtres orthogonaux à 2 sous-bandes, que deux situations peuvent se présenter, selon l'ordre du filtre. Plus précisément, on montre qu'il n'y a aucune solution pour les filtres d'ordre N = 4n, et que les cas N = 4n +1 et N = 4n + 3 sont équivalents (théorème 2), en ce sens qu'ils produisent des composantes polyphasés similaires. La condition pour obtenir une interférence entre symboles nulle est précisée par le théorème 1.

Le cas des filtres d'ordre 4n + 3 est décrit par la suite. Il s'avère être celui permettant d'obtenir la réalisation la plus simple. Le cas 4n + 2 est traité à l'annexe 3, et le cas 4n + 1 (ou 4n + 5) à l'annexe 5.

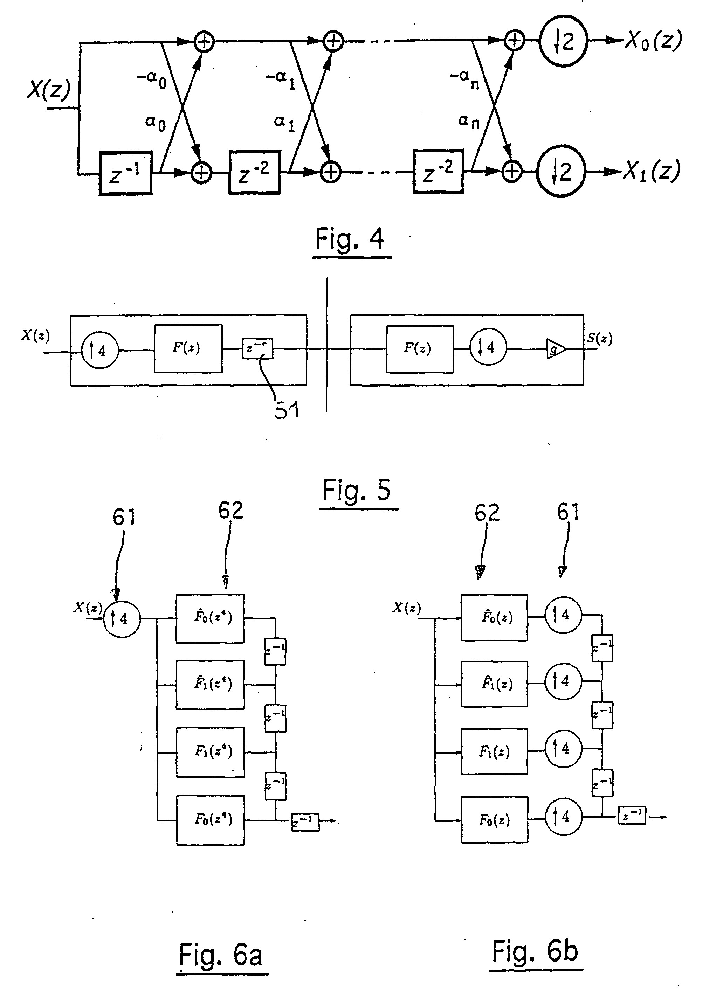

D'une façon générale, le schéma de base mis en oeuvre est représenté en figure 5. Par rapport an schéma initial général de la figure 1, on note que FT(z) 122 et FR(z) 151 sont remplacés par F(z). Il s'agit en effet d'une paire adaptée à phase linéaire.

On note également l'introduction d'une ligne à retard z-r 51, où r est une valeur entière positive dépendante de l'ordre, qui permet dans tous les cas d'obtenir une IES nulle avec un retard donné. Le facteur multiplicatif g 52 permet d'assurer qu'au retard près, la sortie soit bien identique à l'entrée.

Dans le cas N = 4n + 3, du fait des relations entre les différentes composantes polyphasés F(z) l'expression (20) de l'annexe 2 peut se réécrire de la façon suivante:

$$F(z) = F_0(z^4) + z^{-1}F_1(z^4) + z^{-2}\hat{F}_1(z^4) + z^{-3}\hat{F}_0(z^4) \tag{31}$$

On sait qu'au délai près les filtres émission et réception sont identiques. Cependant, si l'on veut tirer le meilleur parti des traitements multicadence, c'est-à-dire interpolation à l'émission, décimation à la réception, les schémas de réalisation ne seront pas exactement les mêmes.

À l'émission, où l'on réalise une interpolation par un facteur M = 4, les formes d'implantation représentées aux figures 6a et 6b, correspondent à celles, dites décomposition polyphasé de type II [4] (les références citées sont regroupées dans l'annexe 7), donnée dans le cas de l'invention par :

$$F(z) = \begin{bmatrix} z^{-3} & z^{-2} & z^{-1} & 1 \end{bmatrix} \begin{bmatrix} \hat{F}_0(z^4) \\ \hat{F}_1(z^4) \\ F_1(z^4) \\ F_0(z^4) \end{bmatrix} \qquad (32)$$

Dans l'une des représentations (figure 6b) on notera la permutation des opérations expansion (61) - filtrage (62), qui permet de réaliser un traitement équivalent en travaillant à une cadence 4 fois moindre que dans le cas du schéma initial (figure 6a).

Dans la partie réception le filtrage est associé à une opération de décimation, pour laquelle une écriture plus appropriée de F(z) est celle de la décomposition polyphase dite de type I [4], qui dans le cas présent peut s'écrire :

$$F(z) = \begin{bmatrix} F_0(z^4) & F_1(z^4) & \hat{F}_1(z^4) & \hat{F}_0(z^4) \end{bmatrix} \begin{bmatrix} 1 \\ z^{-1} \\ z^{-2} \\ z^{-3} \end{bmatrix} \qquad (33)$$

On note que, par rapport à la figure 5, le délai est tel que r=1.

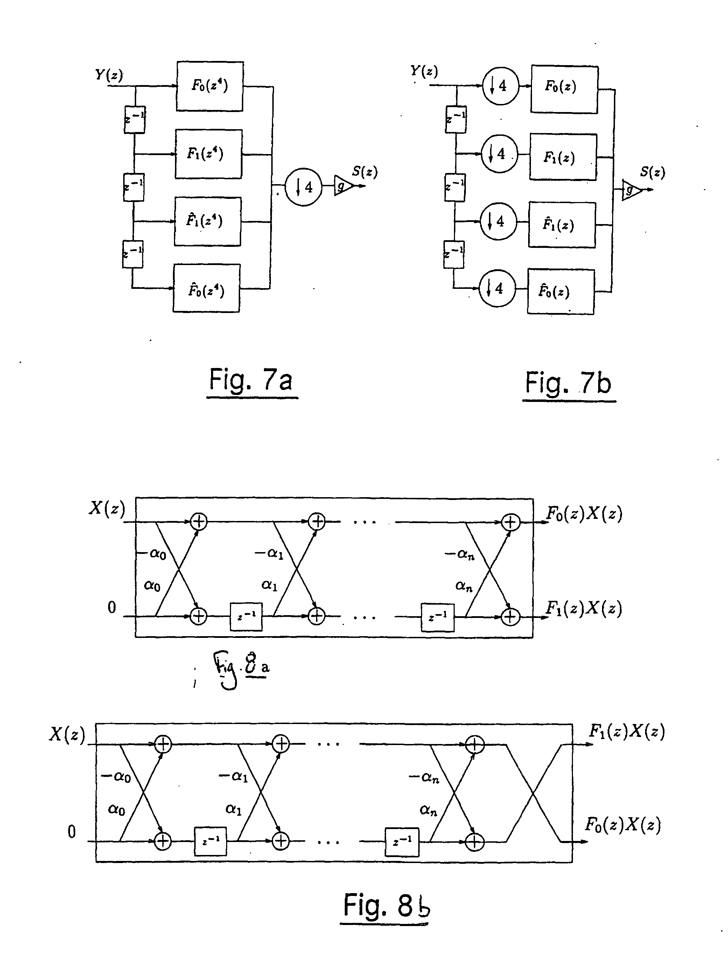

Deux variantes de l'implantation de cette dernière équation sont données à aux figures 7a et 7b (symétriquement aux figures 6a et 6b).

L'analogie entre le filtre F(z) d'ordre 4n + 3 et le banc de filtres d'ordre 2n + 1, décrite par le théorème 3 (annexe 2), permet aussi de réécrire l'équation sous la forme :

$$\begin{bmatrix} F_0(z) & -\hat{F}_1(z) \\ F_1(z) & \hat{F}_0(z) \end{bmatrix} = gA(\alpha_n)\Lambda(z)A(\alpha_{n-1})...\Lambda(z)A(\alpha_0) \qquad (34)$$

Les deux paires de composantes polyphasés, miroirs l'une de l'autre, se déduisent donc par les 2 équations qui suivent

$$\begin{bmatrix} F_0 \\ F_1 \end{bmatrix} = gA(\alpha_n)\Lambda(z)A(\alpha_{n-1})...\Lambda(z)A(\alpha_0) \begin{bmatrix} 1 \\ 0 \end{bmatrix} \qquad (35)$$

et

$$\cdot \begin{bmatrix} -\hat{F}_1 \\ \hat{F}_0 \end{bmatrix} = gA(\alpha_n)\Lambda(z)A(\alpha_{n-1})\dots\Lambda(z)A(\alpha_0)\begin{bmatrix} 0 \\ 1 \end{bmatrix} \qquad (36)$$

Dans chacun de ces cas, la structure treillis, représentée aux figures 8a et 8b, est la même.

Les deux variantes à sorties directes ou invereées de la figure 8 permettent ensuite de réaliser les filtres émission et réception suivant les schémas représentés respectivement aux figures 9 et 10. On notera que les symboles en sortie des filtres indiquent seulement quels sont les filtres actifs.

En utilisant la décomposition polyphase du signal d'entrée, on peut ensuite déterminer un schéma équivalent à un seul treillis mais qui, dans ce cas, est contraint de fonctionner à la fréquence double.

Dans le schéma proposé on présente le treillis inversé sachant que, bien entendu, le treillis direct conduit à un schéma de même type. La figure 11 rappelle les équations de base de ce treillis.

Le signal de sortie du filtre d'émission s'exprime par

$$Y(z) = z^{-1}\left[F_0(z^4) + z^{-1}F_1(z^4) + z^{-2}\hat{F}_1(z^4) + z^{-3}\hat{F}_0(z^4)\right]X(z^4) \qquad (37),$$

ce qui peut se réécrire :

$$Y(z) = z^{-1}\left[F_0(z^4) + z^{-2}\hat{F}_1(z^4)\right]X(z^4) + z^{-2}\left[F_1(z^4) + z^{-2}\hat{F}_0(z^4)\right]X(z^4)$$
$$= \left[Y_0(z^2) + z^{-1}Y_1(z^2)\right]z^{-1} \qquad (38)$$

Une division par 2 du facteur d'expansion ($\uparrow 4 \equiv \uparrow 2 \uparrow 2$), puis une permutation de l'expansion par 2 avec le filtrage produit des sorties filtrées telles que :

$$Y_0(z) = \left[F_0(z^2)X(z^2) + z^{-1}\hat{F}_1(z^2)X(z^2)\right]$$
$$Y_1(z) = \left[F_1(z^2)X(z^2) + z^{-1}\hat{F}_0(z^2)X(z^2)\right] \qquad (39).$$

On reconnait dans $Y_1(z)$ la sortie supérieure du treillis inversé fonctionnant à cadence double, et, au signe du terme en facteur de $z^{-1}$ près, dans $Y_0(z)$ la sortie inférieure. Pour retrouver exactement la même expression, il suffit donc de multiplier cette sortie du treillis inverse par $(-1)^n$.

Une réalisation basée sur ce principe est représenté à la figure 12.

Pour la partie réception, on peut considérer deux cas :

- le cas général, avec 4 treillis, qui satisfont l'ensemble des propriétés désirées (figure 10) ;
- le schéma simplifié, pour lequel seul l'IES nulle et la linéarité de phase à l'émission sont garanties (figure 10bis).

Cet aspect particulier est discuté en annexe 4.

Dans le cas de la figure 9, on fonctionne à la fréquence la plus basse. Le coût de chaque filtre correspond à une structure treillis à n + 1 cellules, plus celui d'une inversion de signe. Pour obtenir un gain unitaire une multiplication par le facteur g est également à comptabiliser pour le schéma du filtre de réception.

Les calculs pour chaque cellule élémentaire correspondent aux 2 multiplieurs et additionneurs. Cependant, comme pour chaque treillis une des entrées est à zéro, un multiplieur et un additionneur peuvent donc être supprimés. le coût est donc de 1 multiplieur et 1 additionneur pour cette première cellule et du double pour les suivantes, c'est-à-dire (2n + 1) multiplieurs et (2n + 1) additionneurs. Pour chaque filtre nous aurons donc (4n + 2) multiplieurs et (4n + 2) additionneurs. À la fréquence la plus basse nous avons donc à réaliser (4n + 2) MPU et (4n +2) APU.

Pour la partie réception, dans le cas du schéma simplifié, illustré par la figure 10bis, la complexité opératoire est d'un seul treillis plus celle des trois additionneurs, du multiplieur par g et de l'inverseur. Les calculs effectués à la cadence la plus basse se chiffrent donc à (2n + 3) MPU, (2n + 5) APU et une inversion.

Dans le cas général illustré par la figure 10, à la fréquence la plus basse, la complexité est de (8n + 4) MPU et APU, et une inversion.

La méthode de synthèse se déroule par exemple en trois étapes, illustrées ci-dessous par le calcul d'un filtre d'ordre 43.

- Etape 1 : A partir d'outils de synthèse [3], il est possible d'obtenir un premier jeu de coefficients transversaux qui soit proche de l'IES nulle. Ce sont les coefficients initiaux de la table 1 ;

- Etape 2 : Par identification, nous pouvons calculer les coefficients treillis initiaux correspondants qui sont donnés sur la table 2. Le jeu initial de coefficients transversaux n'étant pas exactement à IES nulle, on obtient ainsi un nouveau jeu de coefficients transversaux, appelé reconstruit (cf. table 1) ;

- Etape 3 : Une optimisation locale des coefficients treillis initiaux permet en suite d'améliorer un peu la réponse en fréquence du filtre. Les tables 1 et 2 donnent les valeurs de ces coefficients treillis et transverses après cette optimisation (tables 1 et 2).

Table 1:

| Coefficients transversaux des filtres symétriques de degré 43. | | | |
|---|---|---|---|
| i | Initial | Reconstruit | Optimisé |
| 0 | 0.006302365568 | 0.006302365568 | 0.00374315552336009 |
| 1 | -0.01335763186 | -0.01335763186 | -0.00764365688411938 |
| 2 | -0.003586256877 | 0.000139948824594686 | 0.000256865997947587 |
| 3 | 0.003281590529 | 0.000296616382849522 | 0.00052452951560661 |
| 4 | 0.008254154585 | 0.00825445268157875 | 0.00210146572675043 |
| 5 | 0.008753151633 | 0.00875251982827294 | 0.00961384935212083 |
| 6 | 0.002954708412 | -0.000818038274240153 | -0.000565430770503378 |
| 7 | -0.006948650815 | -0.00231664836261536 | -0.00210883853472157 |
| 8 | -0.01474214438 | -0.0147620230725521 | -0.00994253905900314 |
| 9 | -0.01369718742 | -0.0136538137768085 | -0.0139493173848354 |
| 10 | -0.001682000235 | 0.00199238622180159 | 0.00140539009490696 |
| 11 | 0.01571460254 | 0.00939101589973353 | 0.00785652590927169 |
| 12 | 0.026870884 | 0.0269017853424573 | 0.0234276140713132 |
| 13 | 0.02112355083 | 0.0209715158594175 | 0.0216783222304717 |
| 14 | -0.003340088297 | -0.0032097877874163 | -0.00339966101869637 |
| 15 | -0.03511243314 | -0.0308000965511264 | -0.0274417538899884 |
| 16 | -0.05300379917 | -0.0530202725288858 | -0.0511658629696837 |
| 17 | -0.0364661812 | -0.0360408764445379 | -0.0377795925012697 |
| 18 | 0.0221698768 | 0.0140041435375816 | 0.0161657062857809 |
| 19 | 0.1105730906 | 0.116698398397514 | 0.109490464868349 |
| 20 | 0.1994492114 | 0.199658215352476 | 0.199471282748299 |
| 21 | 0.2550483644 | 0.253344105750997 | 0.257329314844394 |

Table 2:

| Coefficients des structures treillis. | | |
|---|---|---|
| | Initiale | Optimisée |
| $g_0$ | 0.006302365568 | 0.003743155523 |
| $\alpha_1$ | 2.1194631945539 | 2.04203561311232 |
| $\alpha_2$ | - 0.7583059650965 | - 0.71854479175763 |
| $\alpha_3$ | 0.6811397085317 | 0.73802350460893 |
| $\alpha_4$ | - 0.4637577935126 | - 0.55360950120952 |
| $\alpha_5$ | 0.4470434662649 | 0.51415010432349 |
| $\alpha_6$ | - 3.7431288142180 | - 5.34790460147966 |
| $\alpha_7$ | - 1.5196264288798 | - 1.52189568702330 |
| $\alpha_8$ | 1.2422617481334 | 1.44910973460487 |
| $\alpha_9$ | - 0.5612421724760 | - 0.63596605846521 |
| $\alpha_{10}$ | 0.1588040486787 | 0.18869460160260 |
| $\alpha_{11}$ | - 0.0222057611677 | - 0.06862284945003 |

La réponse en fréquence pour le filtre d'ordre 43 calculé de cette manière est reportée à la figure 13.

Il s'agit ici d'un premier résultat, qui peut encore être affiné. Par ailleurs, bien sûr, d'autres techniques de calcul peuvent être envisagées, pour différents ordres et contraintes techniques.

On rappelle notamment que le cas N = 4n + 2 est présenté en annexe 3. Par ailleurs, l'annexe 5 discute le cas N = 4n + 1 (ou 4n + 5).

Des précisions sur l'évaluation de la complexité des filtres de réception et une méthode de synthèse générique sont développés en annexe 6. On notera que cette méthode de synthèse s'applique aux trois types de solutions discutés ci-dessus.

## ANNEXE 1

La répartition du filtrage de Nyquist sur 2 filtres, de ce fait couramment appelés filtres en racine de Nyquist, ou en raccourci demi-Nyquist, doit tenir compte de contraintes liées à l'IES, aux spécifications fréquentielles, à la linéarité de la phase et à la propriété dite de paire adaptée. Dans ce paragraphe nous précisons ces différentes notions en supposant, pour simplifier la notation, que $T$ = 1. Par ailleurs, dans le cadre de la réalisation proposée, nous ne traitons que du cas des filtres à Réponse Impulsionnelle Finie (RIF).

### 1- Interférence Entre Symboles (IES)

Soit $x(n)$ le signal d'entrée et $X(z)$ sa transformée en z, i.e. $X(z) = \Sigma_n x(n) z^{-n}$, et convenons de noter suivant le même principe l'ensemble des signaux du système de transmission. La contrainte d'IES nulle revient à imposer que, en l'absence de bruit, le signal de sortie, noté $S(z)$, soit identique, à un retard près, à $X(z)$.

Soit $Y(z)$ le signal en sortie de l'émetteur, il peut s'écrire

$$Y(z) = F_T(z)X(z^M). \tag{1}$$

En sortie du filtre de réception le signal, noté $U(z)$, a pour expression

$$U(z) = F_T(z)F_R(z)X(z^M). \tag{2}$$

Le signal de sortie est donc tout simplement

$$S(z) = \frac{1}{M} \sum_{k=0}^{M-1} U(z^{\frac{1}{M}} w^k) = \left[ \frac{1}{M} \sum_{k=0}^{M-1} F_T(z^{\frac{1}{M}} w^k) F_R(z^{\frac{1}{M}} w^k) \right] X(z), \qquad (3)$$

où

$$w = e^{\frac{2j\pi}{M}}$$

est une racine Mième de l'unité. La condition d'IES nulle peut alors se résumer à l'équation

$$\frac{1}{M} \sum_{k=0}^{M-1} F_T(z^{\frac{1}{M}} w^k) F_R(z^{\frac{1}{M}} w^k) = z^{-d},\qquad (4)$$

où d correspond au retard introduit par les 2 filtres.

Soit $P(z)$ le filtre produit, i.e $P(z) = F_T(z)F_R(z)$. Dans un formalisme habituel en traitement multicadence du signal, l'équation (4) peut alors se réécrire

$$P(z) \downarrow_M = z^{-d}. \qquad (5)$$

Un filtre $P(z)$ qui vérifie cette relation est un filtre de Nyquist, ou encore un filtre Mième de bande.

Soient $n_T$ et $n_R$ les ordres respectifs des filtres RIF d'émission et de réception, le filtre $P$ est donc d'ordre $n_P = n_T + n_R$ et il peut se mettre sous la forme

$$P(z) = \sum_{n=0}^{n_P} p(n) z^{-n}. \qquad (6)$$

Si l'équation (5) n'est pas vérifiée, on mesure habituellement la "distance" par rapport à cette propriété par l'une ou l'autre des expressions qui suivent

$$D_1 = \frac{1}{|p(d)|} \sum_{kM \neq d} |p(d - kM)|, \qquad (7)$$

ou

$$D_2 = \frac{1}{p^2(d)} \sum_{kM \neq d} p^2(d - kM). \qquad (8)$$

**2- Les spécifications fréquentielles**

La figure 2 représente une spécification fréquentielle typique pour les filtres en transmission numérique :

- Le facteur de retombée, en anglais le "roll-off", définit pour ce filtres passe-bas, la bande passante par $[0, \omega_p = \frac{\pi}{M}(1 - \rho)]$ et la bande atténuée par $[\omega_s = \frac{\pi}{M}(1 + \rho), \pi]$.

- Les spécifications d'ondulation en bande passante, notée $\delta_1$, et en bande atténuée, notée $\delta_2$, sont en général les mêmes pour les filtres d'émission et de réception.

- À la pulsation $\pi/M$, on impose en général la contrainte $F_R(\pi/M) = F_T(\pi/M) = \sqrt{2}/2$.

### 3- La linéarité de phase

Le choix de filtres à caractéristique phase-fréquence parfaitement linéaire est en général recommandé pour les systèmes de transmission numérique [1, p 325]. Cela a en particulier l'avantage de préserver les instants de passage par zéros des trains binaires transmis.

### 4- La paire de filtres adaptée

Dans le cas de modulations linéaires, si on suppose que l'IES est nulle pour l'ensemble du système de transmission, et que le bruit du canal est additif, blanc et gaussien (BBAG), on sait que la paire adaptée, i.e. $F_T(z) = z^{-N}F_R(z^{-1})$, avec $N = n_T = n_R$ l'ordre de chaque filtre, est optimale pour le critère signal à bruit (SNR) [2, pp. 51 sq.]. Le SNR qui vaut

$$\frac{E}{N_0} \frac{1}{\|F_R\|^2 \|F_T\|^2} \quad [3]$$

atteint alors son maximum avec $\|F_R\|^2\|F_T\|^2 = 1$.

### ANNEXE 2

1- Bancs de filtres orthogonaux à 2 sous-bandes

Un banc de filtres à 2 sous-bandes peut se représenter suivant le schéma de la figure 3. De manière à satisfaire la condition de non repliement les filtres de synthèse $G_0(z)$ et $G_1(z)$ se déduisent directement des filtres d'analyse par $G_0(z) = H_1(-z)$ et $G_1(z) = -H_0(-z)$.

On peut montrer ensuite [4] que la condition de reconstruction parfaite (PR) peut s'exprimer à partir de la seule matrice polyphase $H_{[H_0,H_1]}(z)$ du banc d'analyse

$$\mathbf{H}_{[H_0,H_1]}(z) = \begin{bmatrix} H_{0,0}(z) & H_{0,1}(z) \\ H_{1,0}(z) & H_{1,1}(z) \end{bmatrix}. \quad (9)$$

où les $H_{k,l}(z)$ sont les composantes polyphases pour chaque filtre $H_k(z)$, i.e.

$$H_k(z) = \sum_{l=0}^{1} z^{-l} H_{k,l}(z^2) \quad (10)$$

Dans le cas des bancs orthogonaux à 2 sous-bandes les filtres sont d'ordre impair $2n + 1$ et les composantes polyphases sont toutes de même degré $n$. Le banc est alors PR si le déterminant de la matrice polyphase est un monôme, autrement dit si

$$\text{Det } H_{[H_0,H_1]}(z) = H_{0,0}(z)H_{1,1}(z) - H_{1,0}(z)H_{0,1}(z) = \beta z^{-n}, \quad (11)$$

avec $\beta$ une constante non nulle.

Soit $Q(z)$ le filtre miroir du filtre $Q(z)$ d'ordre m, i.e. $\hat{Q}(z) = z^{-m}Q(z^{-1})$. Le banc orthogonal se caractérise par des filtres $H_0(z)$ et $H_1(z)$ dits conjugués en quadrature, ce qui peut s'écrire $H_1(z) = \pm z^{-(2n+1)}H_0(z^{-1})$. Dans ce qui suit, contrairement à la présentation faite en [4], nous choisissons l'écriture avec un signe plus. Dans ces conditions les composantes polyphases satisfont la relation

$$H_{0,1}(z) = -\hat{H}_{1,0}(z), \ H_{1,1}(z) = \hat{H}_{0,0}(z). \quad (12)$$

Par conséquent la matrice polyphase peut s'exprimer par

$$H_{[H_0,H_1]}(z) = \begin{bmatrix} H_{0,0}(z) & -\hat{H}_{1,0}(z) \\ H_{1,0}(z) & \hat{H}_{0,0}(z) \end{bmatrix}, \tag{13}$$

et la relation (11) peut se réécrire sous la forme

$$\text{Det } H_{[H_0, H_1]}(z) = H_{0,0}(z)\hat{H}_{0,0}(z) + H_{1,0}(z)\hat{H}_{1,0}(z) = \beta z^{-n}, \tag{14}$$

Le signal de sortie est alors tel que $\hat{X}(z) = \gamma z^{-(2n+1)}X(z)$, avec $\gamma$ une constante non nulle. La matrice $H_{[H_0,H_1]}(z)$ est paraunitaire et peut se mettre sous forme cascade avec [4]

$$H_{[H_0,H_1]}(z) = gA(\alpha_n)\Lambda(z)A(\alpha_{n-1})...\Lambda(z)A(\alpha_0), \tag{15}$$

où $g$ est une constante de normalisation non nulle, $\alpha_0,..., \alpha_n$ sont $n+1$ nombres réels et où les matrices $\mathbf{A}(\alpha)$ pour $\alpha$ réel et $\Lambda(z)$ sont définies par

$$\mathbf{A}(\alpha) = \begin{bmatrix} 1 & \alpha \\ -\alpha & 1 \end{bmatrix} \quad, \quad \Lambda(z) = \begin{bmatrix} 1 & 0 \\ 0 & z^{-1} \end{bmatrix} \tag{16}$$

Une réalisation d'un banc de synthèse basé sur cette écriture mathématique produit la représentation treillis de la figure 4.

**2- Caractéristiques générales du cas de la paire adaptée à phase linéaire pour $M = 4$**

Pour la paire adaptée à phase linéaire nous avons forcément $F_T(z)$ et $F_R(z)$ symétriques tels que $F_T(z) = F_R(z)$, que l'on peut noter avec la seule expression $F(z)$. Soit $N$ l'ordre de $F(z)$, nous avons donc

$$F(z) = \sum_{k=0}^{N} f_k z^{-k} \tag{17}$$

Le filtre produit $P(z)$ s'exprime alors par

$$P(z) = F^2(z) = \sum_{k=0}^{2N} p(k)z^{-k} \tag{18}$$

avec, bien sûr; $p(k) = p(2N - k)$. $P(z)$ satisfait la condition d'IES nulle (5) si

$$p(k) = 0 \text{ pour } k - N = 4l, \ l \neq 0, \tag{19}$$

On peut faire un premier constat en ce qui concerne les filtres d'ordre $N = 4n$.

Proposition 1 .- *Soit $F(z)$ un filtre symétrique d'ordre $4n$. $F(z)$ ne peut être à IES nulle.*

Pour que $F(z)$, filtre symétrique, soit à IES nulle il faut que $f_0 \neq 0$. Le monôme de plus haut degré de $P(z)$ est $f_0^2 z^{-8n}$ alors que son terme central est de degré $4n$ en $z^{-1}$. Comme la différence des degrés est un multiple de 4, $F(z)$ n'est pas à IES nulle.

La décomposition polyphase de $F(z)$ pour $M = 4$ s'écrit sous la forme

$$F(z) = F_0(z^4) + z^{-1}F_1(z^4) + z^{-2}F_2(z^4) + z^{-3}F_3(z^4). \tag{20}$$

avec

$$F_l(z) = \sum_{n=0}^{n_l} f_{4n+l} z^{-n} \tag{21}$$

Pour réaliser l'analyse des différents cas possibles en fonction de l'ordre $N$, on utilise la propriété de symétrie de $F(z)$ et le fait que $4n_l + l \leq N$.

- Si $N = 4n$, le degré de $F_0(z)$ est égal à $n$ et celui des $F_i(z)$, $i = 1, 2, 3$ est strictement inférieur à $n$. D'après la proposition 1 on sait que ce cas ne présente pas d'intérêt pour notre problème.

- Si $N = 4n + 1$, $F_1(z)$ est de degré $n$, $F_0(z)$ de degré $\leq n$ tandis que $F_2(z)$ et $F_3(z)$ sont de degré $\leq n - 1$. $F_1(z)$ correspond alors par symétrie miroir à $F_0(z)$. $F_1(z)$ est donc en fait de degré $n$. On a donc

$$F_0(z) = \hat{F}_1(z) \text{ et } F_3(z) = \hat{F}_2(z) \tag{22}$$

- Si $N = 4n + 2$, il vient $n_2 = n$, $n_1 = n$ et $n_3 = n - 1$. $F_2(z)$ est le symétrique de $F_0(z)$, on a donc

$$F_2(z) = \hat{F}_0(z), \; F_1(z) = \hat{F}_1(z), \; F_3(z) = \hat{F}_3(z) \tag{23}$$

- Si $N = 4n + 3$, $4n_l + l \leq 4n + 3$, $\forall l \, (0 \leq l \leq 3)$, et les filtres $F_i$ sont tous de degré $\leq n$. En effet, le terme de plus haut degré de $F_0(z)$ est de degré $4n + 3$ donnant un terme de degré $n$ à $F_3(z)$. Le terme de plus haut degré de $F_3(z)$ correspond par symétrie au terme constant de $F_0(z)$. On a donc

$$F_3(z) = \hat{F}_0(z) \text{ et } F_2(z) = \hat{F}_1(z) \tag{24}$$

**Remarque.-** Dans l'équation (22) on a écrit à dessein $F_0(z) = \hat{F}_1(z)$ et non $F_1(z) = \hat{F}_0(z)$ car on est sûr que le degré de $F_1(z)$ est $n$ puisque le terme constant de $F_0(z)$ est non nul, mais pas que le degré de $F_0(z)$ est $n$. D'ailleurs ce cas, où $f_1 = f_{N-1} = 0$, est considéré plus bas.

On développe alors le produit $F^2(z)$ en tenant compte de la décomposition (20) et l'on obtient la caractérisation suivante des filtres $F(z)$ vérifiant la propriété d'IES nulle.

**Théorème 1.-** *Soit $F(z)$ un filtre symétrique d'ordre N vérifiant $F(z = 0) \neq 0$. Alors suivant les valeurs de N, F(z) est à IES nulle si et seulement si* :

- *Si $N = 4n + 1$,*

$$F_1(z)\hat{F}_1(z) + z^{-1}F_2(z)\hat{F}_2(z) = \gamma z^{-n}, \tag{25}$$

- *Si $N = 4n + 2$,*

$$2F_0(z)\hat{F}_0(z) + F_1^2(z) + z^{-1}F_3^2(z) = \gamma z^{-n}, \tag{26}$$

- *Si $N = 4n + 3$,*

$$F_0(z)\hat{F}_0(z) + F_1(z)\hat{F}_1(z) = \gamma z^{-n}, \tag{27}$$

*où $\gamma$ est une constante non nulle.*

Le théorème suivant montre que toutes les solutions d'ordre $N = 4(n-1)+3$ s'obtiennent à partir des solutions d'ordre $N = 4n + 1$.

**Théorème 2.-** *Soit $F(z)$ un filtre symétrique à IES nulle d'ordre $4n + 1$, $n \geq 1$, alors si $F_i(z)$, $i = 0,..., 3$ désigne ses composantes polyphases, $F_0(z)$ est de degré strictement inférieur à $n$ et $F_1(z)$ peut s'écrire sous la forme $F_1(z) = z^{-1}K_1(z)$. On a alors $K_1(z) = F_0(z)$ et le filtre $\bar{F}(z)$ de composantes polyphasés $[F_0(z), F_2(z), F_3(z), K_1(z)]$ est symétrique d'ordre $4(n - 1) + 3$ et à IES nulle.*

**Démonstration.-** Cela résulte immédiatement de la relation (25) puisque le terme constant du membre de gauche est nul. On a donc $F_1(z = 0)F_1(z = 0) = f_0 f_1 = 0$. Comme $F_1(z)$ contribue avec $f_0$ au terme de plus haut degré, $f_0 \neq 0$ et donc $f_1 = 0$. En écrivant $F_1(z)$ sous la forme $F_1(z) = z^{-1}K_1(z)$ et sachant que $F_1(z) = K_1(z)$, la relation (26), peut encore s'écrire

$$z^{-1}K_1(z)\hat{K}_1(z) + z^{-1}F_2(z)\hat{F}_2(z) = \gamma z^{-n}, \tag{28}$$

Comme $\hat{K}_1(z) = F_0(z)$ et donc $K_1(z) = \hat{F}_0(z)$ on obtient la relation (27), pour un filtre où $K_1(z)$ se substitue à $F_3(z)$ et a donc pour composantes polyphases : $[F_0(z), F_2(z), F_3(z), K_1(z)]$. On peut vérifier sur un exemple le passage d'un filtre d'ordre 9 à un filtre d'ordre 7.

*Exemple*

$$
\begin{aligned}
F_0(z) &= f_0 + f_4 z^{-1} + f_1 z^{-2} &= f_0 + f_4 z^{-1} \\
F_1(z) &= f_1 + f_4 z^{-1} + f_0 z^{-2} &= z^{-1}(f_4 + f_0 z^{-1}) &= z^{-1}K_1(z) \\
F_2(z) &= f_2 + f_3 z^{-1} \\
F_3(z) &= f_3 + f_2 z^{-1}
\end{aligned}
\tag{29}
$$

Le filtre composé de $[F_0(z), F_2(z), F_3(z), K_1(z)]$ est d'ordre 7 et s'exprime alors par

$$f_0 + f_2 z^{-1} + f_3 z^{-2} + f_4 z^{-3} + f_4 z^{-4} + f_3 z^{-5} + f_2 z^{-6} + f_0 z^{-7} \tag{30}$$

Un troisième théorème montre que les solutions d'ordre $N = 4n+3$ s'obtiennent à partir des bancs de filtres orthogonaux à 2 sous-bandes.

**Théorème 3.-** *Soit $[H_0(z), H_1(z)]$ un banc de filtres orthogonaux à deux sous bandes et d'ordre $2n + 1$ dont la matrice polyphasé est donnée par (13), alors le filtre $\bar{H}(z)$ dont les quatre composantes polyphasés sont $[H_{0,0}(z), H_{1,0}(z), H_{1,0}(z), H_{0,0}(z)]$ est un filtre à phase linéaire, d'ordre $4n + 3$ et à IES nulle. De façon réciproque, tous les filtres de ce type s'obtiennent à partir des bancs de filtres orthogonaux à deux sous-bandes.*

**Démonstration.-** La démonstration est immédiate puisque les filtres à phase linéaire, d'ordre $4n + 3$ et à IES nulle sont caractérisés par la relation (27) qui, dans les conditions du théorème devient équivalente à (14).

**ANNEXE 3**

**Paire de Nyquist d'ordre $N = 4n + 2$**

**1- Factorisation initiale**

Le théorème 1 en annexe 2 nous donne, entre autres, la condition que doit réaliser un filtre $F(z)$ d'ordre $4n + 2$ pour être à IES nulle. On rappelle qu'elle s'écrit

$$2F_0(z)\hat{F}_0(z) + F_1^2(z) + z^{-1}F_3^2(z) = \gamma z^{-n}, \tag{31}$$

où $\gamma$ est une constante non nulle et où les composantes $F_i(z)$ sont toutes de degré $n$, hormis $F_3(z)$, et satisfont les relations $F_2(z) = F_0(z)$, $F_1(z) = F_1(z)$ et $F_3(z) = F_3(z)$.

**Théorème 4.-** *Soient $a_i$, $i$ 1, ...., $n + 1$, $n \geq 0$, $n + 1$ constantes. On considère le vecteur colonne $[F_0(z), F_1(z), F_2(z), F_3(z)]^T$ défini par l'égalité*

$$\begin{bmatrix} F_0(z) \\ F_1(z) \\ F_2(z) \\ F_3(z) \end{bmatrix} = M(a_1)\ Z\ M(a_2)\ Z\ \dots\ Z\ M(a_n)\ Z \begin{bmatrix} 1 \\ a_{n+1} \\ 1 \\ 0 \end{bmatrix},\quad (32)$$

*Alors le filtre $F(z)$, dont les composantes polyphases sont les $F_i(z)$, $i = 1,..., ,4$, est à phase linéaire, monique, d'ordre $4n + 2$ et à IES nulle.*

*Réciproquement, tout filtre monique d'ordre $4n + 2$, à phase linéaire et à IES nulle admet une décomposition de cette forme.*

**Démonstration.-** Pour $n = 0$, les composantes polyphases sont les polynômes constants $F_0(z) = 1$, $F_1(z) = a_1$, $F_2(z) = 1$ et $F_3(z) = 0$. Ces polynômes vérifient trivialement la condition (31) ainsi que les conditions de symétrie et de degré. On a alors $F(z) = 1 + a_1 z^{-1} + z^{-2}$. Supposons maintenant que les composantes d'un filtre $F(z)$ d'ordre $4n + 2$, $F_i(z)$,$i = 0,...,3$, vérifient la condition (31) ainsi que les conditions de symétrie et de degré. Construisons $L_i(z)$,$i = 0,..., 3$ par

$$\begin{bmatrix} L_0(z) \\ L_1(z) \\ L_2(z) \\ L_3(z) \end{bmatrix} = M(a_1)\ Z \begin{bmatrix} F_0(z) \\ F_1(z) \\ F_2(z) \\ F_3(z) \end{bmatrix}.\qquad (33)$$

On a

$$L_0(z) = F_0(z) - \frac{a_1^2}{2} z^{-1} F_2(z) + a_1 z^{-1} F_3(z),\qquad (34)$$

$$L_1(z) = -a_1 F_0(z) - a_1 z^{-1} F_2(z) + (1 - \frac{a_1^2}{2}) z^{-1} F_3(z),\qquad (35)$$

$$L_2(z) = -\frac{a_1^2}{2} F_0(z) + z^{-1} F_2(z) + a_1 z^{-1} F_3(z),\qquad (36)$$

$$L_3(z) = (1 + \frac{a_1^2}{2}) F_1(z).\qquad (37)$$

Il est à peu près immédiat de vérifier les conditions de degré et de symétrie sur les composantes $L_i(z)$, $i = 0,..., 3$. En développant l'expression analogue de (31) pour les composantes $L_i(z)$,$i = 0,... ,3$, on obtient

$$2L_0(z)\hat{L}_0(z) + L_1^2(z) + z^{-1} L_3^2(z) = \frac{(2+a_1^2)^2}{4}\ z^{-1}\ (2F_0(z)\hat{F}_0(z) + F_1^2(z) + z^{-1} F_3^2(z))\qquad (38)$$

D'après (31), la partie directe du théorème est donc démontrée.

La réciproque est démontrée si l'on peut établir que les relations (34-37) permettent de déterminer de manière unique un coefficient $a_1$ et les composantes $F_i(z)$, $i = 0,...,3$ d'un filtre $F(z)$ monique, à phase linéaire et à IES nulle.

Comme on doit avoir $F_0(z = 0) = 1$ (puisque $F(z)$ est monique et symétrique, son terme constant est égal à 1), d'après (35) on a $a_1 = -L_1(z = 0)$. Si $a_1 = 0$, alors nous sommes dans le cas particulier où $L_0(z)$ est de degré $n$, le terme de degré $n +1$ étant nul, le polynôme symétrique $L_1(z)$ a un terme constant nul et son terme de plus haut degré est nul, et enfin le terme constant de $L_2(z)$ est nul (mais pas son terme de degré $n + 1$ dont le coefficient est 1). On inverse alors les relations (34-37) par $F_0(z) = L_0(z)$, $F_1(z) = L_3(z)$, $F_2(z) = L_2(z)$ quo $z^{-1}$ et $F_3(z) = L_1(z)$ quo $z^{-1}$. On suppose donc maintenant que $a_1 \neq 0$, mais ce n'est pas nécessaire en fait. L'inversion formelle des formules (34-37) conduit à

$$F_0(z) = \frac{4}{(2 + a_1^2)^2} \left( L_0(z) - a_1 L_1(z) - \frac{a_1^2}{2} L_2(z) \right) , \qquad (39)$$

$$F_1(z) = \frac{2}{2 + a_1^2} L_3(z), \qquad (40)$$

$$F_2(z) = \frac{4}{(2 + a_1^2)^2} \left( -\frac{a_1^2}{2} L_0(z) - a_1 L_1(z) + L_2(z) \right) \text{ quo } z^{-1} , \qquad (41)$$

$$F_3(z) = \frac{4}{(2 + a_1^2)^2} \left( a_1 L_0(z) + (1 - \frac{a_1^2}{2}) L_1(z) + a_1 L_2(z) \right) \text{ quo } z^{-1} \quad (42)$$

Il suffit alors de montrer que les quotients par $z^{-1}$ sont exacts. Comme $F(z)$ est monique, $L_0(z = 0) = 1$, $L_1(z = 0) = -a_1$ par définition de $a_1$ et, d'après la relation (31), $L_2(z = 0) = -a_1^2/2$. Les membres de droites des égalités définissant $F_2(z)$ et $F_3(z)$ s'annulent donc en $z = 0$ et les quotients sont exacts. On peut alors vérifier que les polynômes $F_i$, $i = 0,...,$ 3 satisfont les conditions de symétrie adéquates.

**2- Décomposition équivalente**

En notant par $\mathbf{R}(\alpha)$ la matrice

$$\mathbf{R}(\alpha) = \begin{bmatrix} \cos \alpha & -\sin \alpha & 0 & 0 \\ \sin \alpha & \cos \alpha & 0 & 0 \\ 0 & 0 & 1 & 0 \\ 0 & 0 & 0 & 1 \end{bmatrix} , \qquad (43)$$

et en utilisant la formule (32), on obtient

$$\begin{bmatrix} F_0(z) \\ F_1(z) \\ F_2(z) \\ F_3(z) \end{bmatrix} = \mathbf{P}^T \, \mathbf{R}(a_1) \, \mathbf{P} \mathbf{Z} \mathbf{P}^T \, \mathbf{R}(a_2) \, \mathbf{P} \mathbf{Z} \mathbf{P}^T \; ... \; \mathbf{P} \mathbf{Z} \mathbf{P}^T \, \mathbf{R}(a_n) \, \mathbf{P} \mathbf{Z} \begin{bmatrix} 1 \\ a_{n+1} \\ 1 \\ 0 \end{bmatrix} .$$

Dans le schéma de l'émission on note par $Ma$ le bloc associé au vecteur de droite. On introduit alors la matrice $\bar{Z}$ définie par

$$\bar{\mathbf{Z}} = \mathbf{P}\mathbf{Z}\mathbf{P}^T = \begin{bmatrix} \frac{1}{2}(1+z^{-1}) & 0 & \frac{1}{2}(-1+z^{-1}) & 0 \\ 0 & 0 & 0 & z^{-1} \\ \frac{1}{2}(-1+z^{-1}) & 0 & \frac{1}{2}(1+z^{-1}) & 0 \\ 0 & 1 & 0 & 0 \end{bmatrix}, \qquad (44)$$

et compte tenu de

$$\mathbf{P}\begin{bmatrix} 1 \\ a_{n+1} \\ 1 \\ 0 \end{bmatrix} = \begin{bmatrix} \sqrt{2} \\ a_{n+1} \\ 0 \\ 0 \end{bmatrix}, \qquad (45)$$

on obtient, avec un facteur multiplicatif $g$, la décomposition

$$\begin{bmatrix} F_0(z) \\ F_1(z) \\ F_2(z) \\ F_3(z) \end{bmatrix} = g\mathbf{P}^T\mathbf{R}(a_1)\,\bar{\mathbf{Z}}\,\mathbf{R}(a_2)\,\bar{\mathbf{Z}}\,\ldots\,\mathbf{R}(a_n)\,\bar{\mathbf{Z}}\begin{bmatrix} 1 \\ a_{n+1} \\ 0 \\ 0 \end{bmatrix}. \qquad (46)$$

*Complexité opératoire*

L'équation (46) donne directement la structure de réalisation des filtres demi-Nyquist d'émission et de réception. Elle correspond à un système à 4 entrées et 4 sorties qui dans les schémas des figures 6 et 7 se substitue à l'ensemble des 4 filtres polyphases. On notera que dans le cas du filtre d'émission les sorties sont à inverser par rapport à l'écriture (46) qui correspond, par contre, exactement, à celle du filtre de réception. Hormis cette différence de détail, les structures pour chacun de ces filtres d'ordre $4n+2$ vont donc correspondre à

- $n$ blocs matriciels de type $\bar{Z}$ et $\mathbf{R}(a_l)$.

- un bloc matriciel $\mathbf{P}^T$.

- un bloc vectoriel $[1, a_{n+1}, 0, 0]^T$.

- un multiplieur $g$, à ne comptabiliser que pour l'émission ou la réception.

Examinons à présent plus en détail le coût de réalisation de chacun de ces élèments.

- Matrices $\mathbf{R}(\alpha_l)$.
  Les matrices $\mathbf{R}(\alpha_l)$, $1 \le l \le n$, sont des matrices blocs qui peuvent se mettre sous la forme

$$\mathbf{R}(\alpha_l) = \begin{pmatrix} \mathbf{G}_l & \mathbf{0} \\ \mathbf{0} & \mathbf{I} \end{pmatrix} \qquad (47)$$

où $\mathbf{I}$ est la matrice unité et $\mathbf{G}_l$ la matrice de rotation pour l'angle $\alpha_l$, i.e.

$$\mathbf{G}_l = \begin{pmatrix} \cos(\alpha_l) & -\sin(\alpha_l) \\ \sin(\alpha_l) & \cos(\alpha_l) \end{pmatrix} \qquad (48)$$

Le coût d'implantation est donc tout simplement celui du treillis correspondant à la rotation $\mathbf{G}_l$, c'est-à-dire 4 multiplications et 2 additions.

- La matrice $\bar{Z}$.

    Elle permet d'associer à un vecteur e d'entrée, le vecteur s de sortie par la relation s = $\bar{Z}$ e, ce qui se traduit par les 4 équations qui suivent :

$$
\begin{aligned}
s_0 &= \tfrac{1}{2}[(e_0 - e_2) + z^{-1}(e_0 + e_2)] \\
s_1 &= z^{-1}e_1 \\
s_2 &= \tfrac{1}{2}[(e_2 - e_0) + z^{-1}(e_0 + e_2)] \\
s_3 &= e_3
\end{aligned}
\tag{49}
$$

Le schéma de réalisation d'un bloc de ce type est représenté à la figure 14. On peut préciser que les multiplications par 1/2 peuvent se réduire à un simple décalage des données binaires. En plus de ces 2 décalages le coût est donc simplement de 4 additions et d'une inversion de signe.

- La matrice $\mathbf{P}^T$.

    Elle se présente sous la forme :

$$
\mathbf{P}^T = \begin{pmatrix} a & 0 & -a & 0 \\ 0 & 1 & 0 & 0 \\ a & 0 & a & 0 \\ 0 & 0 & 0 & 1 \end{pmatrix}
\tag{50}
$$

avec

$$
a = \frac{1}{\sqrt{2}}.
$$

Sa réalisation peut également se déduire des équations d'entrée-sortie, qui dans le cas présent s'écrivent :

$$
\begin{aligned}
s_0 &= a(e_0 + e_2) \\
s_1 &= e_1 \\
s_2 &= a(-e_0 + e_2) \\
s_3 &= e_3
\end{aligned}
\tag{51}
$$

de manière immédiate on peut donc déduire ensuite le schéma de la figure 15.

    Le coût opératoire est de 2 multiplications, 2 additions et une inversion de signe.

- Le bloc vectoriel $[1, a_{n+1}, 0, 0]^T$.

    Son coût d'implantation est d'une seule multiplication.

Le schéma complet d'implantation, conforme à l'équation (46), correspond donc à un système à 4 entrées et 4 sorties, tel qu'on le représente à la figure 16. On retrouve naturellement ce système à l'émission et à la réception. L'ordre de complexité de chacun de ces filtres est donc de $4n$ MPU et $6n$ APU.

Ainsi que nous l'avons déjà précisé, à l'émission il est nécessaire d'inverser les sorties. Dans le schéma de réalisation reporté à la figure 17, cette opération est symbolisée par le bloc J, correspondant à la matrice antidiagonale, i.e.

$$J = \begin{pmatrix} 0 & 0 & 0 & 1 \\ 0 & 0 & 1 & 0 \\ 0 & 1 & 0 & 0 \\ 1 & 0 & 0 & 0 \end{pmatrix} \tag{52}$$

Le schéma de réception pour l'ordre $4n + 2$ est représenté aux figures 18 et 19. Il se déduit des calculs qui suivent.

On introduit la matrice $\hat{Z}$ définie par

$$\hat{Z} = \begin{bmatrix} \frac{1}{2}(1 + z^{-1}) & 0 & \frac{1}{2}(1 - z^{-1}) & 0 \\ 0 & 0 & 0 & z^{-1} \\ \frac{1}{2}(1 - z^{-1}) & 0 & \frac{1}{2}(1 + z^{-1}) & 0 \\ 0 & 1 & 0 & 0 \end{bmatrix} .$$

C'est la matrice obtenue en prenant les éléments "miroirs" des éléments de la matrice $\bar{Z}$. On a

$$\bar{Z}\,\hat{Z} = z^{-1}\,I_4,$$

où $I_4$ est la matrice identité d'ordre 4.

On vérifie ensuite les identités

$$P\,P^T = I_4,\; R(a)^{-1} = R(a)^T = R(-a)$$

pour toute valeur de $a$.

En notant $M$ le produit matriciel

$$M = P^T R(a_1)\bar{Z}...R(a_n)\bar{Z}$$

et $N$ le produit matriciel

$$N = \hat{Z}R(-a_n) ... \hat{Z}R(-a_1)P$$

on a donc

$$NM = z^{-n}I_4,$$

et par conséquent

$$N \begin{bmatrix} F_0(z) \\ F_1(z) \\ F_2(z) \\ F_3(z) \end{bmatrix} = gz^{-n} \begin{bmatrix} 1 \\ a_{n+1} \\ 0 \\ 0 \end{bmatrix} .$$

On introduit alors la matrice $K$ définie par

$$K = \begin{bmatrix} 1 & 0 & 0 & 0 \\ 0 & 1 & 0 & 0 \\ 1 & 0 & 0 & 0 \\ 0 & 0 & 0 & 1 \end{bmatrix} .$$

La figure 19 donne le schéma de réalisation du bloc correspondant à la matrice **N** et la figure 20 le schéma de réalisation du filtrage de réception qui en résulte. Si la constante $g$ est égale à $1/(1 + a_{n+1})$, alors un signal transmis par le système d'émission de la figure 17 et reçu ensuite par le système de la figure 20, produit un signal identique avec un retard de $n + 2$ échantillons.

**ANNEXE 4**

**Schéma de réception à un seul treillis**

Si on suppose un fonctionnement dit "dos-à-dos", il est en effet possible de simplifier le schéma de la figure 10 en utilisant l'équation assurant une IES nulle, on obtient alors le schéma à un seul treillis de la figure 10 bis. Dans ce cas seules l'IES nulle et la linéarité de phase du filtre d'émission sont assurées.

La validité de ce schéma de la figure 10 bis peut se vérifier à partir de l'équation (37) du brevet, après multiplication par $z^{-1}$. Pour un système dit dos-à-dos, le signal d'entrée du filtre de réception est donné par

$$Y(z) = z^{-1}[F_0(z^4) + z^{-1}F_1(z^4) + z^{-2}\hat{F}_1(z^4) + z^{-3}\hat{F}_0(z^4)]X(z^4) \tag{53}$$

En référence à la figure 10 bis, les signaux après décimation sont, de haut en bas, donnés par

$$\begin{aligned} Y(z) \downarrow_4 &= z^{-1}\hat{F}_0(z)X(z), & z^{-1}Y(z) \downarrow_4 &= z^{-1}\hat{F}_1(z)X(z), \\ z^{-2}Y(z) \downarrow_4 &= z^{-1}F_1(z)X(z), & z^{-3}Y(z) \downarrow_4 &= z^{-1}F_0(z)X(z) \end{aligned} . \tag{54}$$

En entrée du treillis direct, les signaux sont donc, de haut en bas, donnés par $z^{-1}[\hat{F}_0(z) + \hat{F}_1(z)]X(z)$ et $z^{-1}[F_0(z) - F_1(z)]X(z)$. Le signal de sortie est donc

$$S(z) = 2gz^{-1}[F_0(z)\hat{F}_0(z) + F_1(z)\hat{F}_1(z)]X(z) = 2gz^{-1}[\gamma z^{-n}], \tag{55}$$

avec

$$\gamma = \prod_{i=0}^{n}(1 + \alpha_i^2).$$

On vérifie ainsi que pour $g = 1/\gamma$, le signal de sortie est identique à celui de l'entrée au retard de $n + 1$ échantillon près.

**ANNEXE 5**

**Cas de l'ordre** $N = 4n + 1$

**Remarque préliminaire :** Pour conserver un treillis à $n + 1$ cellules, de coefficients $\alpha_i$ avec $0 \le i \le n$, tel que celui défini pour l'ordre $4n + 3$, nous présentons le cas de l'ordre $4n + 5$.

Soient $L_i$, $i = 0,...,3$ les composantes polyphases d'un filtre $L(z)$ à IES nulle d'ordre $4n + 3$. On peut lui associer un treillis construit comme dans la figure 8 a) du brevet avec un jeu de coefficients $\alpha_i$, $i = 0,...,n$. On a $L_2(z) = L_1(z)$ et $L_3(z) = L_0(z)$. Le filtre $F(z)$ dont les composantes $F_i$, $i = 0,...,3$ sont définies par

$$F_0(z) = L_0(z), \tag{56}$$

$$F_1(z) = z^{-1}\hat{L}_0(z), \tag{57}$$

$$F_2(z) = L_1(z), \tag{58}$$

$$F_3(z) = \hat{L}_1(z), \tag{59}$$

est un filtre à IES nulle et à phase linéaire d'ordre $4n+5$. De plus le théorème 2 en annexe 2 du brevet établit que de tels filtres sont nécessairement obtenus de cette manière. Bien entendu, la synthèse d'un tel filtre est conduite de manière à optimiser les coefficients $\alpha_i$, $i = 0,..., n$ pour obtenir de bonnes spécifications fréquentielles pour le filtre $F(z)$, pas pour le filtre $L(z)$ ! Cela conduit donc à la réalisation de schémas pour l'émission et la réception associée à $F(z)$ à partir du treillis construit avec les coefficients $\alpha_i$ et du treillis inverse associé.

La décomposition polyphase de type I appliqué à ce filtre se traduit par l'expression

$$F(z) = L_0(z^4) + z^{-1}[z^{-4}\hat{L}_0(z^4)] + z^{-2}L_1(z^4) + z^{-3}\hat{L}_1(z^4) \tag{60}$$

On peut vérifier que, pour la partie émission, cette équation peut se traduire par le schéma en treillis de la figure 20, dans laquelle on applique un retard donné par $z^{-3}$ en sortie de $F(z)$.

Pour la partie réception, comme dans le cas de l'ordre $4n + 3$, il est possible de réaliser un système à 4 treillis, qui garantit l'ensemble des propriétés recherchées.

De même des simplifications apparaissent si on considère le système dit dos-à-dos. Le signal d'entrée du filtre de réception peut alors s'écrire

$$Y(z) = [z^{-3}L_0(z^4) + z^{-8}[z^{-4}\hat{L}_0(z^4)] + z^{-5}L_1(z^4) + z^{-6}\hat{L}_1(z^4)]X(z^4) \tag{61}$$

Pour récupérer, à un retard près, le signal d'entrée nous mettons alors en oeuvre le dispositif de la figure 21.

En référence à la figure 21, les signaux après décimation sont, de haut en bas, donnés par

$$\begin{array}{ll} Y(z)\downarrow_4 = z^{-2}\hat{L}_0(z)X(z), & z^{-1}Y(z)\downarrow_4 = z^{-1}L_0(z)X(z), \\ z^{-2}Y(z)\downarrow_4 = z^{-2}\hat{L}_1(z)X(z), & z^{-3}Y(z)\downarrow_4 = z^{-2}L_1(z)X(z) \end{array} . \tag{62}$$

De haut en bas, les signaux en entrée du treillis sont respectivement donnés par

$$z^{-2}[\hat{L}_0(z) + \hat{L}_1(z)]X(z) \text{ et } z^{-2}[L_0(z) - L_1(z)]X(z).$$

Nous trouvons donc comme pour le cas de l'ordre $4n + 3$, mais avec cette fois un retard de traitement de $n + 2$ échantillons, un signal de sortie qui pour $g = 1/(2\gamma)$ est identique à celui d'entrée.

## ANNEXE 6

### 1- L'évaluation de la complexité des filtres de réception

Deux cas sont à considérer suivant que l'on veut ou non conserver l'ensemble des propriétés recherchées. Ainsi pour les filtres d'ordre $4n + 3$ et $4n + 5$

- Pour conserver l'IES nulle, la paire adaptée, la linéarité de phase des filtres émission et réception, comme indiqué à la figure 10, 4 treillis sont utilisés qui fonctionnent à la cadence la plus basse. Compte tenu que pour chaque treillis 2 multiplications et additions sont nécessaires, sauf pour chaque première cellule (un multiplieur et un additionneur), la complexité opératoire est de ($8n$ + 4) MPU et APU, plus une inversion de signe.

- Pour un système dos-à-dos des simplifications sont possibles mais seules l'IES nulle et la linéarité de phase du filtre d'émission sont garanties. Pour les filtres de réception d'ordre $4n$ + 3 et $4n$ + 5 simplifiés la complexité opératoire correspond alors à celle d'un seul treillis plus celle des 3 additionneurs, du multiplieur par $g$ et de l'inverseur. Les calculs effectués à la cadence la plus basse se chiffrent donc à ($2n$ + 3) MPU, ($2n$ + 5) APU et une inversion.

**2- Une méthode de synthèse générique**

Par rapport à la méthode de synthèse proposée initialement nous avons actuellement une méthode de synthèse qui permet de satisfaire, pour les 3 types de solution, une spécification fréquentielle telle que celle représentée à la figure 2.

Pour un filtre $F(z)$ de longueur donnée $L$, différente de $4n$ + 1, autrement dit pour un ordre $N$ différent de $4n$, et pour une valeur fixée du facteur $\rho$ de retombée, nous cherchons à minimiser la fonction coût

$$\Phi(F) = \sup\{w_P(1 - |F(1)|)^2, w_C\left(\frac{\sqrt{2}}{2} - |F(e^{j\frac{\pi}{8}})|\right)^2, w_S \sup_{[\omega_S, \pi]} |F(e^{j\omega})|^2\}.$$

Nous utilisons l'algorithme FSQP ("Feasible Sequential Quadratic Programming") développé par l'équipe de A.L. Tits [5] pour la recherche du minimum d'un ensemble de fonctions coût régulières non linéaires soumises à des contraintes générales, régulières et non linéaires, Comme cette méthode est une méthode d'optimisation locale, le choix d'un point initial est nécessaire. Pour un poids donné w dans la bande d'arrêt et un poids égal à 1 à l'origine et en la fréquence de Nyquist, c'est-à-dire $\pi/8$, nous calculons un filtre initial $F^{init}$ optimal pour la norme du minimax. Ce filtre $F^{init}$ est ensuite utilisé pour calculer directement un ensemble de coefficients treillis pour un filtre produisant une paire adaptée à IES nulle. Puisque $F^{init}$ ne produit pas lui-même une paire adaptée à IES nulle, l'identification entre les deux ensembles de coefficients, les coefficients transversaux de $F^{init}$ et les coefficients treillis, n'est pas exactement réalisée. Nous obtenons par conséquent un filtre différent, noté $\bar{F}^{init}$, dont les coefficients treillis sont considérés comme point initial du problème d'optimisation décrit par (63). Pour ce problème, nous fixons $w_P$ = 1, $w_C$ = 2, $w_s$ = 0.5.

De plus, pour toute structure treillis optimisée pour une valeur donnée $\rho_0$, nous utilisons également un algorithme de "continuation" pour obtenir une structure treillis optimisée pour une valeur $\rho_1$ différente en considérant une suite de valeur intermédiaires pour $\rho$ : le résultat de la structure treillis optimisée pour une valeur de $\rho$ dans la suite est le point initial pour la valeur suivante de $\rho$.

La figure 22 montre la meilleure atténuation dans la bande d'arrêt que nous avons pu obtenir pour une longueur et un facteur de retombée fixés.

Considérons par exemple les valeurs $L$ = 43 et $\rho$ = 0.5 : la meilleure atténuation, obtenue par optimisation directe, est égale à 52.28 dB. La réponse fréquentielle du filtre d'émission correspondant, $F^{opt}$, est donnée par la figure 23. Les coefficients transversaux et les coefficients de la structure treillis sont donnés dans la table 3.

| Coefficients transversaux | | | |
|---|---|---|---|
| $f_0$ | $-1.033698\ 10^{-4}$ | $f_{11}$ | $8.074275371845\ 10^{-3}$ |
| $f_1$ | $-3.6954272174\ 10^{-4}$ | $f_{12}$ | $1.5774357742194\ 10^{-2}$ |
| $f_2$ | $6.60549905248\ 10^{-4}$ | $f_{13}$ | $1.2603068512975\ 10^{-2}$ |
| $f_3$ | $-1.09979829792\ 10^{-4}$ | $f_{14}$ | $-6.358804372375\ 10^{-3}$ |
| $f_4$ | $4.31563793685\ 10^{-4}$ | $f_{15}$ | $-3.3366501346017\ 10^{-2}$ |
| $f_5$ | $6.08998879046\ 10^{-4}$ | $f_{16}$ | $-4.6538674170018\ 10^{-2}$ |
| $f_6$ | $6.39123817678\ 10^{-4}$ | $f_{17}$ | $-2.1044564354449\ 10^{-2}$ |
| $f_7$ | $-7.82626716253\ 10^{-4}$ | $f_{18}$ | $5.1214636348857\ 10^{-2}$ |
| $f_8$ | $-3.761395765875\ 10^{-3}$ | $f_{19}$ | $1.51186813816588\ 10^{-1}$ |
| $f_9$ | $-4.983816032565\ 10^{-3}$ | $f_{20}$ | $2.39358058463701\ 10^{-1}$ |
| $f_{10}$ | $-9.24070721312\ 10^{-4}$ | $f_{21}$ | $2.74720061562686\ 10^{-1}$ |

| Coefficients treillis | |
|---|---|
| $\alpha_1$ | $-3.1848708937$ |
| $\alpha_2$ | $2.648518499\ 10^{-1}$ |
| $\alpha_3$ | $-2.9385797132$ |
| $\alpha_4$ | $-9.349457966\ 10^{-1}$ |
| $\alpha_5$ | $9.246893837\ 10^{-1}$ |
| $\alpha_6$ | $-1.308356726\ 10^{-1}$ |
| $\alpha_7$ | $3.6683584963$ |
| $\alpha_8$ | $-6.126257549\ 10^{-1}$ |
| $\alpha_9$ | $-1.2465410017$ |
| $\alpha_{10}$ | $-1.439677875\ 10^{-1}$ |
| $\alpha_{11}$ | $-3.5749582735$ |

Table 3 : Coefficients treillis et tranversaux de l'exemple avec $L = 43$ et $\rho = 0.5$ $(f_{42-i} = f_i)$.

**ANNEXE 7**

**References**

[1] J. G. Proakis. *Digital Communications.* McGrawhill, 1983.

**EP 1 101 283 B1**

[2] R. W. Lucky, J. Salz, and E. J. Weldon, Jr. *Principles of Data Communications*. Mc Grawhill, New-York, 1968.

[3] P. Siohan and F. Moreau de Saint-Martin. "New designs of linear-phase transmitter and receiver filters for digital transmission systems". *IEEE Transactions on Circuits and Systems II*, 46(4):428-433, April 1999.

[4] P. P. Vaidyanathan. *Multirate systems and filter banks.* Prentice Hall, Englewood Cliffs, New-York, New Jersey, 1993.

[5] C. T. Lawrence and A. L. Tits. "Nonlinear equality constraints in feasible sequential quadratic programming". *Optimization Methods and Software*, 6:265-282, 1996.

**Revendications**

1. Procédé de réalisation d'un filtre numérique de Nyquist à interférences nulles entre symboles, destiné à traiter un signal physique transmis entre un émetteur et un récepteur via un canal de transmission,
ledit filtre étant un filtre symétrique $P(z) = F^2(z)$ d'ordre N mettant en oeuvre un facteur de suréchantillonnage M=4, et formant une paire adaptée comprenant un filtre d'émission (12) et un filtre de réception (15),
la décomposition polyphase de F(z) s'écrivant :

$$F(z) = F_0(z^4) + z^{-1}F_1(z^4) + z^{-2}F_2(z^4) + z^{-3}F_3(z^4)$$

**caractérisé en ce que** N est différent de 4n, n entier,
et **en ce que** :

. Si N=4n+1, $\quad F_1(z)\hat{F}_1(z) + z^{-1}F_2(z)\hat{F}_2(z) = \gamma z^{-n}$

. Si N=4n+2, $\quad 2F_0(z)\hat{F}_0(z) + F_1^2(z) + z^{-1}F_3^2(z) = \gamma z^{-n}$

. Si N=4n+3, $\quad F_0(z)\hat{F}_0(z) + F_1(z)\hat{F}_1(z) = \gamma z^{-n}$

$\hat{F}$ étant la symétrie miroir de F et $\gamma$ étant une constante non nulle.

2. Procédé selon la revendication 1, **caractérisé en ce que** N vaut 4n+3 ou 4n+1 et **en ce que** :

- ledit un filtre d'émission (12) effectue une interpolation (121) par un facteur M=4 et présente une implantation correspondant à une décomposition polyphase dite de type II, telle que :

$$F(z) = \begin{bmatrix} z^{-3} & z^{-2} & z^{-1} & 1 \end{bmatrix} \begin{bmatrix} \hat{F}_0(z^4) \\ \hat{F}_1(z^4) \\ F_1(z^4) \\ F_0(z^4) \end{bmatrix}$$

- et ledit filtre de réception (15) effectue une décimation (152) par un facteur M=4 et présente une implantation correspondant à une décomposition polyphase dite de type I, telle que :

$$F(z) = \begin{bmatrix} F_0(z^4) & F_1(z^4) & \hat{F}_1(z^4) & \hat{F}_0(z^4) \end{bmatrix} \begin{bmatrix} 1 \\ z^{-1} \\ z^{-2} \\ z^{-3} \end{bmatrix}$$

3. Procédé selon l'une quelconque des revendications 1 et 2, **caractérisé en ce que**, dans ledit filtre d'émission (12), on effectue une étape de filtrage suivie d'une étape d'interpolation par un facteur M=4.

4. Procédé selon l'une quelconque des revendications 1 à 3, **caractérisé en ce que**, dans ledit filtre de réception (15), on effectue une étape de décimation par un facteur M=4 suivie d'une étape de filtrage.

5. Procédé selon l'une quelconque des revendications 1 à 4, **caractérisé en ce que** ledit filtre d'émission (12) et/ou ledit filtre de réception (15) présente une structure de réalisation sous forme d'au moins un treillis.

6. Procédé selon la revendication 5, **caractérisé en ce que** ledit filtre d'émission (12) et ledit filtre de réception (15) sont constitué chacun d'une paire de composantes polyphases donnée respectivement par les équations suivantes :

$$\begin{bmatrix} F_0 \\ F_1 \end{bmatrix} = gA(\alpha_n)\Lambda(z)A(\alpha_{n-1})...\Lambda(z)A(\alpha_0)\begin{bmatrix} 1 \\ 0 \end{bmatrix}$$

$$\begin{bmatrix} -\hat{F}_1 \\ \hat{F}_0 \end{bmatrix} = gA(\alpha_n)\Lambda(z)A(\alpha_{n-1})...\Lambda(z)A(\alpha_0)\begin{bmatrix} 0 \\ 1 \end{bmatrix}$$

avec:

$$A(\alpha) = \begin{bmatrix} 1 & \alpha \\ -\alpha & 1 \end{bmatrix} \qquad et \qquad \Lambda(z) = \begin{bmatrix} 1 & 0 \\ 0 & z^{-1} \end{bmatrix}$$

où g est une constante non nulle de normalisation et $\alpha_i$ des coefficients réels.

7. Procédé selon la revendication 6, **caractérisé en ce qu'**il met en oeuvre une structure à deux treillis.

8. Procédé selon la revendication 6, **caractérisé en ce qu'**il met en oeuvre une structure à treillis unique, fonctionnant à une fréquence double.

9. Dispositif de filtrage d'un signal numérique de Nyquist à interférences nulles entre symboles, destiné à traiter un signal physique transmis entre un émetteur et un récepteur via un canal de transmission, basé sur un filtre symétrique $P(z) = F^2(z)$ d'ordre N mettant en oeuvre un facteur de suréchantillonnage M=4, et formant une paire adaptée comprenant un filtre d'émission (12) et un filtre de réception (15), la décomposition polyphase de F(z) s'écrivant :

$$F(z) = F_0(z^4) + z^{-1}F_1(z^4) + z^{-2}F_2(z^4) + z^{-3}F_3(z^4)$$

**caractérisé en ce que** N est différent de 4n, n entier,
et **en ce que** :

. Si N=4n+1, $\quad F_1(z)\hat{F}_1(z) + z^{-1}F_2(z)\hat{F}_2(z) = \gamma z^{-n}$

. Si N=4n+2, $\quad 2F_0(z)\hat{F}_0(z) + F_1^2(z) + z^{-1}F_3^2(z) = \gamma z^{-n}$

. Si N=4n+3, $\quad F_0(z)\hat{F}_0(z) + F_1(z)\hat{F}_1(z) = \gamma z^{-n}$

$\hat{F}$ étant la symétrie miroir de F et $\gamma$ étant une constante non nulle.

**Patentansprüche**

1. Verfahren zur Herstellung eines digitalen Nyquistfilters mit Nullinterferenz zwischen den Symbolen, zum Verarbeiten eines physikalischen Signals, das zwischen einem Sender und einem Empfänger über einen Sendekanal übertragen wird,
   wobei es sich um ein symmetrisches Filter $P(z) = F^2(z)$ N-ter Ordnung handelt, das ein Überabtastverfahren M = 4 anwendet und ein angepasstes Paar, das ein Sendefilter (12) und ein Empfangsfilter (15) aufweist,
   wobei die Mehrphasenzerlegung von F(z) folgendermaßen geschrieben wird:

$$F(z) = F_0(z^4) + z^{-1}F_1(z^4) + z^{-2}F_2(z^4) + z^{-3}F_3(z^4)$$

**dadurch gekennzeichnet, dass** N verschieden von 4n ist, wobei n eine ganze Zahl ist und dass:

. wenn N = 4n + 1 $\quad F_1(z)\hat{F}_1(z) + z^{-1} F_2(z)\hat{F}_2(z) = \gamma z^{-n}$

. wenn N = 4n + 2 $\quad 2F_0(z)\hat{F}_0(z) + F_1^2(z) + z^{-1} F_3^2(z) = \gamma z^{-n}$

. wenn N = 4n + 3 $\quad F_0(z)\hat{F}_0(z) + F_1(z)\hat{F}_1(z) = \gamma z^{-n}$

wobei $\hat{F}$ die Spiegelsymmetrie von F und $\gamma$ eine Konstante ist, die nicht gleich null ist.

2. Verfahren nach Anspruch 1, **dadurch gekennzeichnet, dass** N gleich 4n + 3 oder 4n + 1 ist und, dass

   - das genannte Sendefilter (12) eine Interpolation (121) um einen Faktor M = 4 ausführt und eine Schaltungsausführung aufweist, die einer als vom Typ II bekannten Mehrphasenzerlegung entspricht, wobei:

$$F(z) = [z^{-3} \ z^{-2} \ z^{-1} \ 1] \begin{vmatrix} \hat{F}_0(z^4) \\ \hat{F}_1(z^4) \\ F_1(z^4) \\ F_0(z^4) \end{vmatrix}$$

   - und, dass das erwähnte Empfangsfilter (15) eine Dezimierung (152) um einen Faktor M = 4 ausführt und eine Schaltungsausführung aufweist, die einer als vom Typ I bekannten Mehrphasenzerlegung entspricht, wobei:

$$F(z) = [F_0 (z^4)\ F_1 (z^4)\ \hat{F}_1 (z^4)\ \hat{F}_0 (z^4)] \begin{bmatrix} 1 \\ z^{-1} \\ z^{-2} \\ z^{-3} \end{bmatrix}$$

**3.** Verfahren nach einem der Ansprüche 1 oder 2, **dadurch gekennzeichnet, dass** man im erwähnten Sendefilter (12) einen Filterungsschritt ausführt, der von einem Interpolationsschritt nach einem Faktor M = 4 gefolgt wird.

**4.** Verfahren nach einem der Ansprüche 1 bis 3, **dadurch gekennzeichnet, dass** in dem erwähnten Empfangsfilter (15) ein Dezimierungsschritt nach einem Faktor M = 4 erfolgt, der von einem Filterungsschritt gefolgt wird.

**5.** Verfahren nach einem der Ansprüche 1 bis 4, **dadurch gekennzeichnet, dass** das Sendefilter (12) und/oder das Empfangsfilter (15) eine Struktur in der Form von mindestens einem Gitter aufweist.

**6.** Verfahren nach Anspruch 5, **dadurch gekennzeichnet, dass** das Sendefilter (12) und das Empfangsfilter (15) jeweils aus einem Paar mehrphasiger Komponenten gebildet werden, die jeweils durch die folgenden Gleichungen gegeben sind:

$$\begin{vmatrix} F_0 \\ F_1 \end{vmatrix} = gA\ (\alpha_n)\ \Lambda(z)\ A(\alpha_{n-1})\ \ldots\ \Lambda(z)\ A(\alpha_0) \begin{vmatrix} 1 \\ 0 \end{vmatrix}$$

$$\begin{vmatrix} -\hat{F}_1 \\ \hat{F}_0 \end{vmatrix} = gA\ (\alpha_n)\ \Lambda(z)\ A(\alpha_{n-1})\ \ldots\ \Lambda(z)\ A(\alpha_0) \begin{vmatrix} 0 \\ 1 \end{vmatrix}$$

wobei:

$$A(\alpha) = \begin{vmatrix} 1 & \alpha \\ -\alpha & 1 \end{vmatrix} \qquad \text{und} \qquad \Lambda(z) = \begin{vmatrix} 1 & 0 \\ 0 & z^{-1} \end{vmatrix}$$

wobei g eine nicht null gleiche Normierungskonstante ist und $\alpha_i$ reelle Koeffizienten sind.

**7.** Verfahren nach Anspruch 6, **dadurch gekennzeichnet, dass** es eine Struktur mit zwei Gittern anwendet.

**8.** Verfahren nach Anspruch 6, **dadurch gekennzeichnet, dass** es eine Struktur mit einem einzigen Gitter anwendet, die bei doppelter Frequenz arbeitet.

**9.** Filterungsverfahren eines digitalen Nyquistsignals mit Nullinterferenzen zwischen den Symbolen, zum Verarbeiten eines physikalischen Signals, das zwischen einem Sender und einem Empfänger über einen Sendekanal übertragen wird,
basierend auf ein symmetrisches Filter $P(z) = F^2(z)$ N-ter Ordnung, das einen Überabtastungsfaktor M = 4 anwendet und ein angepasstes Paar bildet, welches ein Sendefilter (12) und ein Empfangsfilter (15) aufweist,
wobei die Mehrphasenzerlegung von F(z) folgendermaßen geschrieben wird:

$$F(z) = F_0(z^4) + z^{-1}F_1(z^4) + z^{-2}F_2(z^4) + z^{-3}F_3(z^4),$$

**dadurch gekennzeichnet, dass** N verschieden von 4n ist, wobei n eine ganze Zahl ist und dass:

- wenn N = 4n + 1     $F_1(z)\hat{F}_1(z) + z^{-1} F_2(z)\hat{F}_2(z) = \gamma z^{-n}$

- wenn N = 4n + 2     $2F_0(z)\hat{F}_0(z) + F_1^2(z) + z^{-1} F_3^2(z) = \gamma z^{-n}$

- wenn N = 4n + 3     $F_0(z)\hat{F}_0(z) + F_1(z)\hat{F}_1(z) = \gamma z^{-n}$

wobei $\hat{F}$ die Spiegelsymmetrie von F und $\gamma$ eine Konstante ist, die nicht gleich null ist.

## Claims

1. Method for the making of a digital Nyquist filter with null intersymbol interference designed to process a physical signal transmitted between a sender and a receiver through a transmission channel,
   said filter being an Nth order $P(z) = F^2(z)$ symmetrical filter implementing an oversampling factor M=4 and forming a matched pair comprising a sending filter (12) and a reception filter (15) whose polyphase breakdown of F(z) can be written as follows:

$$F(z) = F_0(z^4) + z^{-1}F_1(z^4) + z^{-2}F_2(z^4) + z^{-3}F_3(z^4)$$

   **characterized in that** N is different from 4n, n being an integer :
   and **in that**:

   - If N=4n+1,     $F_1(z)\hat{F}_1(z) + z^{-1} F_2(z)\hat{F}_2(z) = \gamma z^{-n}$

   - If N=4n+2,     $2F_0(z)\hat{F}_0(z) + F_1^2(z) + z^{-1} F_3^2(z) = \gamma z^{-n}$

   - If N=4n+3,     $F_0(z)\hat{F}_0(z) + F_1(z)\hat{F}_1(z) = \gamma z^{-n}$ being $\hat{F}$ the mirror symmetry of F and $\gamma$ being a non-null constant.

2. Method according to claim 1, **characterized in that** N is equal to 4n+3 or 4n+1 and:
   said sending filter (12) performs an interpolation (121) by a factor M = 4 and has a circuit arrangement corresponding to a polyphase breakdown known as the type II breakdown, such that:

$$F(z) = [z^{-3}\ z^{-2}\ z^{-1}\ 1]\begin{bmatrix} \hat{F}_0(z^4) \\ \hat{F}_1(z^4) \\ F_1(z^4) \\ F_0(z^4) \end{bmatrix}$$

   and said reception filter (15) performs a decimation (152) by a factor M = 4 and has a circuit arrangement corresponding to a polyphase breakdown known as the type I breakdown, such that:

$$F(z) = [F_0\,(z^4)\ F_1\,(z^4)\ \hat{F}_1\,(z^4)\ \hat{F}_0\,(z^4)] \begin{bmatrix} 1 \\ z^{-1} \\ z^{-2} \\ z^{-3} \end{bmatrix}$$

3.  Method according to any of the claims 1 and 2, **characterized in that**, in said sending filter (12), a filtering step followed by a step of interpolation by a factor of M=4 is performed.

4.  Method according to any of the claims 1 à 3, **characterized in that**, in said reception filter (15), a step of decimation by a factor M=4 is performed, followed by a filtering step.

5.  Method according to any of the claims 1 to 4, **characterized in that** said sending filter (12) and/or said reception filter (15) have a structure in the form of at least one lattice.

6.  Method according to claim 5, **characterized in that** said sending filter (12) and said reception filter (15) are each constituted by a pair of polyphase components respectively given by the following equations :

$$\begin{bmatrix} F_0 \\ F_1 \end{bmatrix} = g A\,(\alpha_n)\,\Lambda(z)\,A(\alpha_{n-1})\,\ldots\,\Lambda(z)\,A(\alpha_0) \begin{bmatrix} 1 \\ 0 \end{bmatrix}$$

$$\begin{bmatrix} -\hat{F}_1 \\ \hat{F}_0 \end{bmatrix} = g A\,(\alpha_n)\,\Lambda(z)\,A(\alpha_{n-1})\,\ldots\,\Lambda(z)\,A(\alpha_0) \begin{bmatrix} 0 \\ 1 \end{bmatrix}$$

with:

$$A(\alpha) = \begin{bmatrix} 1 & \alpha \\ -\alpha & 1 \end{bmatrix} \qquad \text{und} \qquad \Lambda(z) = \begin{bmatrix} 1 & 0 \\ 0 & z^{-1} \end{bmatrix}$$

where g is a non-null constant of standardisation and $\alpha_i$ are real coefficients.

7.  Method according to claim 6, **characterized in that** it implements a two-lattice structure.

8.  Method according to claim 6, **characterized in that** it implement a single-lattice structure working at a double frequency.

9.  Device for the filtering of Nyquist digital signals with null intersymbol interference designed to process a physical signal transmitted between a sender and a receiver through a transmission channel,
    based on an Nth order $P(z) = F^2(z)$ symmetrical filter implementing an oversampling factor M = 4 and forming a matched pair comprising a sending filter (12) and a reception filter (15),
    the polyphase breakdown of F(z) of this symmetrical filter being written as follows:

$$F(z) = F_0(z^4) + z^{-1}F_1(z^4) + z^{-2}F_2(z^4) + z^{-3}F_3(z^4),$$

**characterized in that** N is different from 4n, n being an integer,

- If N=4n+1, $\quad F_1(z)\hat{F}_1(z) + z^{-1} F_2(z)\hat{F}_2(z) = \gamma z^{-n}$

- If N=4n+2, $\quad 2F_0(z)\hat{F}_0(z) + F_1^2(z) + z^{-1} F_3^2(z) = \gamma z^{-n}$

- If N=4n+3, $\quad F_0(z)\hat{F}_0(z) + F_1(z)\hat{F}_1(z) = \gamma z^{-n}$ being $\hat{F}$ the mirror symmetry of F and $\gamma$ being a non-null constant.

## Fig. 1

$X(z)$   $\boxed{\downarrow M}$   $\boxed{F_T(z)}$   $Y(z)$   $\boxed{F_R(z)}$   $U(z)$   $\boxed{\downarrow M}$   $S(z)$

121   122   151   152

11   12   13   14   15   16

## Fig. 2

$2\delta_1$

$1$

$\dfrac{\sqrt{2}}{2}$

$\delta_2$

$0$   $(1-\rho)\dfrac{\pi}{M}$   $\dfrac{\pi}{M}$   $(1+\rho)\dfrac{\pi}{M}$   $\pi$

## Fig. 3

$X(z)$

$\boxed{H_1(z)} \longrightarrow \boxed{\downarrow 2} \longrightarrow \boxed{\uparrow 2} \longrightarrow \boxed{G_1(z)}$

$\boxed{H_0(z)} \longrightarrow \boxed{\downarrow 2} \longrightarrow \boxed{\uparrow 2} \longrightarrow \boxed{G_0(z)}$

$\hat{X}(z)$

Fig. 4

Fig. 5

Fig. 6a

Fig. 6b

Fig. 7a

Fig. 7b

Fig. 8 a

Fig. 8 b

Fig. 9

Fig. 10

Fig. 10 bis

Fig. 11

## Fig. 12

## Fig. 13

Fig. 14

Fig. 15

**Fig. 16**

**Fig. 17**

## Fig. 18

## Fig. 19

Fig. 20

Fig 21

Fig. 22

Fig. 23